# EUROPEAN PATENT APPLICATION

(11) **EP 0 741 495 A2**
(43) Date of publication of application: **06.11.1996**
(21) Application number: 96302988.9
(22) Date of filing: 29.04.1996
(51) Int. Cl.: H04N 5/445

(54) **Program-related information display method and apparatus**

(30) Priority: 02.05.1995 JP 108746/95
(71) Applicant: SONY CORPORATION, Tokyo (JP)
(72) Inventor: Nakano, Hiroaki, c/o Sony Corp., Shinagawa-ku, Tokyo (JP); Niijima, Makoto, c/o Sony Corp., Shinagawa-ku, Tokyo (JP); Sonoda, Yumie, c/o Sony Corp., Shinagawa-ku, Tokyo (JP); Kumagai, Yoshiaki, c/o Sony Corp., Shinagawa-ku, Tokyo (JP); Nagahara, Junichi, c/o Sony Corp., Shinagawa-ku, Tokyo (JP); Tamori, Hirofumi, c/o Sony Corp., Shinagawa-ku, Tokyo (JP)
(74) Representative: Ayers, Martyn Lewis Stanley

(57) **Abstract**

The invention provides an electronic apparatus which allows characters relating to a program to be observed at hand. A program selection screen transmitted via a satellite and including a plurality of reduced screens is displayed on a monitor apparatus. A cursor is moved to a particular one of the reduced screens to select the particular reduced screen. Character information such as a title, an elapsed time from a start time of broadcasting and so forth of the reduced screen at which the cursor is positioned is displayed on a display section of a cordless telephone set (child machine) which serves as a remote commander.

## Description

This invention relates to a program-related information displaying method and apparatus, and more particularly to a program-related information displaying method and apparatus by which character information relating to a program can be visually observed at hand.

In recent years, the number of broadcasting channels has increased in a cable television (CATV) system or a digital direct satellite broadcasting system (DSS: Digital Satellite System, a trademark of Hughes Communications) in the United States of America applying a high efficiency coding technique such as the MPEG (Moving Picture Experts Group). As a result of an increase in number of channels, for example 150 to 200 broadcasting channels, are now available.

Also, in Japan, a digital television broadcast is being planned. If a digital television broadcast becomes available, then a very large number of television programs can be broadcast.

Where the number of programs increases in this manner, it is difficult to select a desired program rapidly with certainty from among a large number of programs. Thus, it has been proposed to broadcast, from a broadcasting station side, a program selection screen (multi-screen) which includes a plurality of reduced screens displaying different programs as an electrical program guide (EPG) so that each customer can select a desired program from within the program selection screen.

It may seem a possible idea to transmit also character information representing contents of reduced screens, elapsed times after broadcasting is started and some other information as EPG data so as to assist a viewer in selection of a program. However, if characters relating to a program of a reduced screen are displayed on the reduced screen, then they are displayed in a very small size. It becomes difficult to read the characters particularly where they are written in the Japanese or Chinese language.

It is an object of the present invention to provide a program relating information displaying method and apparatus by which character information can be read readily by a viewer.

In order to attain the object described above, according to an aspect of the present invention, there is provided an electronic apparatus to which a program relating information display apparatus is applied, the electronic apparatus being remotely controlled by a remote commander, comprising program reception means for receiving a program and character information relating to the program transmitted thereto over a channel, and character information transmission means for transmitting the character information to the remote commander in order to cause (allow) the remote commander to display the character information.

In the electronic apparatus, the program reception means receives a program and character information relating to the program transmitted thereto over a channel, and the character information transmission means transmits the character information to the remote commander so as to be displayed on the remote commander.

With the electronic apparatus, since the character information is transmitted to the remote commander, characters of the character information can be discerned with certainty at hand on the remote commander.

According to another aspect of the present invention, there is provided a program relating information displaying method, comprising the steps of receiving a program and character information relating to the program transmitted over a channel by an electronic apparatus which is remotely controlled by a remote commander, and transmitting the program information from the electronic apparatus to the remote commander so as to be displayed on the remote commander.

In the program relating information displaying method, a program and character information relating to the program transmitted over a channel by an electronic apparatus which is remotely controlled by a remote commander are received, and the program information is transmitted from the electronic apparatus to the remote commander so as to be displayed on the remote commander

With the method, since the character information is transmitted to the remote commander, characters of the character information can be discerned with certainty at hand on the remote commander.

According to a further aspect of the present invention, there is provided a remote commander to which a program relating information display apparatus is applied, the remote commander remotely controlling an electronic apparatus which receives a program transmitted thereto over a channel, the remote commander comprising character information reception means for receiving character information relating to the program transmitted thereto from the electronic apparatus, and display means for displaying the character information received by the character information reception means.

In the remote commander, the character information reception means receives character information relating to a program transmitted thereto from the electronic apparatus, and the display means displays the character information received by the character information reception means.

With the remote commander, since character information relating a program is received by and displayed on the remote commander which remotely controls the electronic apparatus, characters of the character information can be discerned at hand on the remote commander, and consequently, the electronic apparatus can be remotely controlled accurately using the remote commander.

According to a still further aspect of the present invention, there is provided a program relating information displaying method, comprising the steps of receiving character information transmitted from an electronic apparatus, which receives a program transmitted thereto over a channel, and relating to the program by means of a remote commander which remotely controls the electronic apparatus, and displaying the received character information on the remote commander.

In the program relating information displaying method, character information transmitted from an electronic apparatus, which receives a program transmitted thereto over a channel, and relating to the program is received by means of a remote commander which remotely controls the electronic apparatus, and the received character information is displayed on the remote commander.

With the program relating information displaying method, since character information relating a program is received by and displayed on the remote commander which remotely controls the electronic apparatus, characters of the character information can be discerned at hand on the remote commander, and consequently, the electronic apparatus can be remotely controlled accurately using the remote commander.

According to a yet further aspect of the present invention, there is provided a remote control method for remotely controlling an electronic apparatus, which receives a program transmitted thereto over a channel, by means of a remote commander which has a function as a telephone set, the remote control method being performed incidentally to a program relating information displaying method, the remote control method comprising the steps of receiving character information transmitted from the electronic apparatus and relating to the program by means of the remote commander, displaying the received character information on the remote commander, and performing, when a key is operated while a telephone number is displayed as the received character information on the remote commander, a call originating operation to the telephone number.

In the remote control method, character information transmitted from the electronic apparatus and relating to a program is received by means of the remote commander, and the received character information is displayed on the remote commander. Then, when a key is operated while a telephone number is displayed as the received character information on the remote commander, a call originating operation to the telephone number is performed.

Accordingly, with the remote control method, not only a call originating operation relating to a program can be performed rapidly and with certainty, but also dialing of a wrong number can be prevented.

The above and other features and advantages of the present invention will become apparent from the following non-limitative description given with reference to the accompanying drawings in which like parts or elements are denoted by like reference characters.

FIGS. 1A to 1D are diagrammatic views illustrating definition of several terms used for description of the present invention;
FIG. 2 is a diagrammatic view illustrating archiving processing;
FIG. 3 is a diagrammatic view showing a broadcasting system to which the present invention is applied;
FIG. 4 is a diagrammatic view illustrating a manner in which archived data are produced;
FIG. 5 is a schematic view illustrating a manner of arrangement of reduced screens;
FIG. 6 is a diagrammatic view showing a more detailed construction of part of the broadcasting system shown in FIG. 3;
FIG. 7 is a diagrammatic view illustrating a link between data of an ordinary program and a reduced screen of the program;
FIG. 8 is a block diagram showing a detailed construction of a receiver shown in FIG. 3;
FIG. 9 is a block diagram showing a detailed construction of a base unit shown in FIG. 8;
FIG. 10 is a front elevational view of a cordless telephone set (child machine);
FIG. 11 is a cross sectional view taken along line X-Y of FIG. 10;
FIGS. 12A to 12C are a front elevational view, a cross sectional view taken along line A-B of FIG. 12B and a rear elevational view showing a construction of a microphone unit shown in FIGS. 10 and 11;
FIG. 13 is a perspective view showing the cordless telephone set (child machine) of FIG. 10 when not in use;
FIG. 14 is a similar view but showing the cordless telephone set (child machine) when in use;
FIG. 15 is a schematic rear elevational view, partly broken, showing a joystick mounted on a body of the telephone set of FIG. 10;
FIG. 16 is an enlarged perspective view showing a detailed construction of the joystick shown in FIG. 11;
FIG. 17 is a diagrammatic view showing operation directions of a lever shown in FIG. 16 in a horizontal plane;
FIG. 18 is a perspective view of the cordless telephone set (child machine) of FIG. 10 illustrating manual operation of the joystick shown in FIG. 11 when the cordless telephone set (child machine) is held by the left hand;
FIG. 19 is a similar view but illustrating manual operation of the joystick when the cordless telephone set (child machine) is held by the right hand;
FIG. 20 is a block diagram showing an internal construction of the cordless telephone set (child machine) of FIG. 10;
FIG. 21 is a block diagram illustrating operation of the arrangement shown in FIG. 8;
FIG. 22 is a diagrammatic view illustrating a manner in which archived data are separated;
FIG. 23 is a diagrammatic view illustrating a condition wherein reduced screens are stored in a matrix array in a virtual frame memory;
FIG. 24 is a schematic view illustrating a relationship between a virtual screen and a selection area;
FIG. 25 is a schematic view showing program selection screens displayed on a monitor apparatus;
FIG. 26 is a schematic view illustrating scrolling of a selection area;
FIGS. 27 and 28 are flow charts illustrating operation of the cordless telephone set (child machine) of FIG. 10;
FIGS. 29 to 33 are schematic views showing different examples of a display of a display section of the cordless telephone set (child machine) of FIG. 10; and
FIG. 34 is a schematic view illustrating a DTMF signal.

Before preferred embodiments of the present invention are described, in order to clearly indicate the corresponding relationship between different elements of the present invention recited in the appended claims and the preferred embodiments of the present invention hereinafter described, the characteristics of the present invention will be described in connection with the elements with corresponding elements of the embodiments added in parentheses.

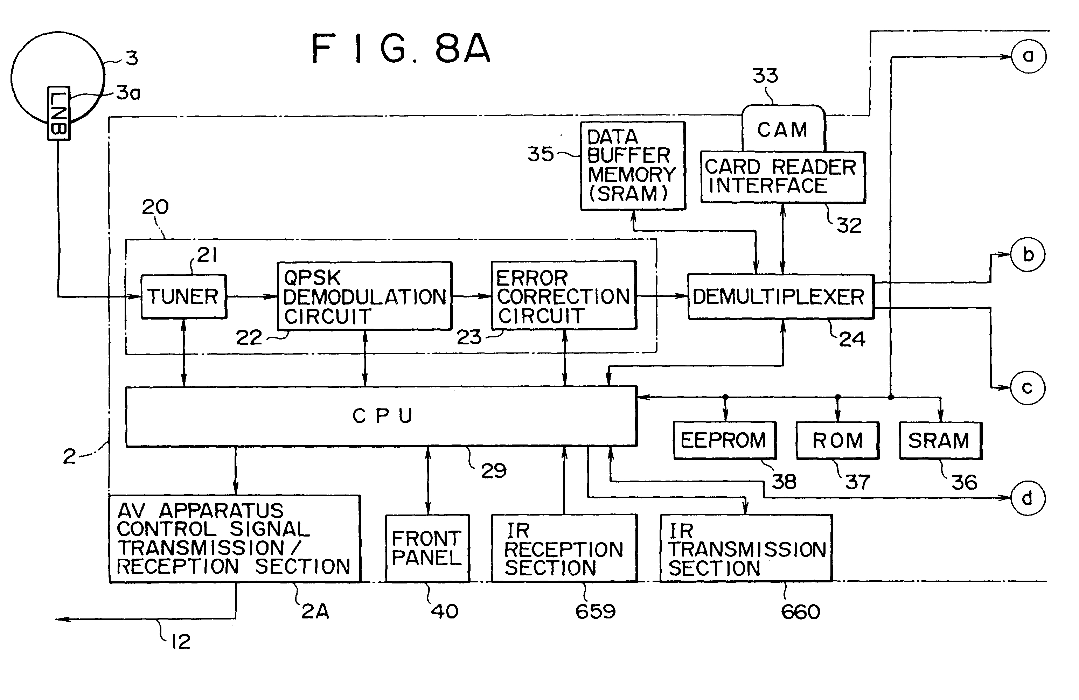

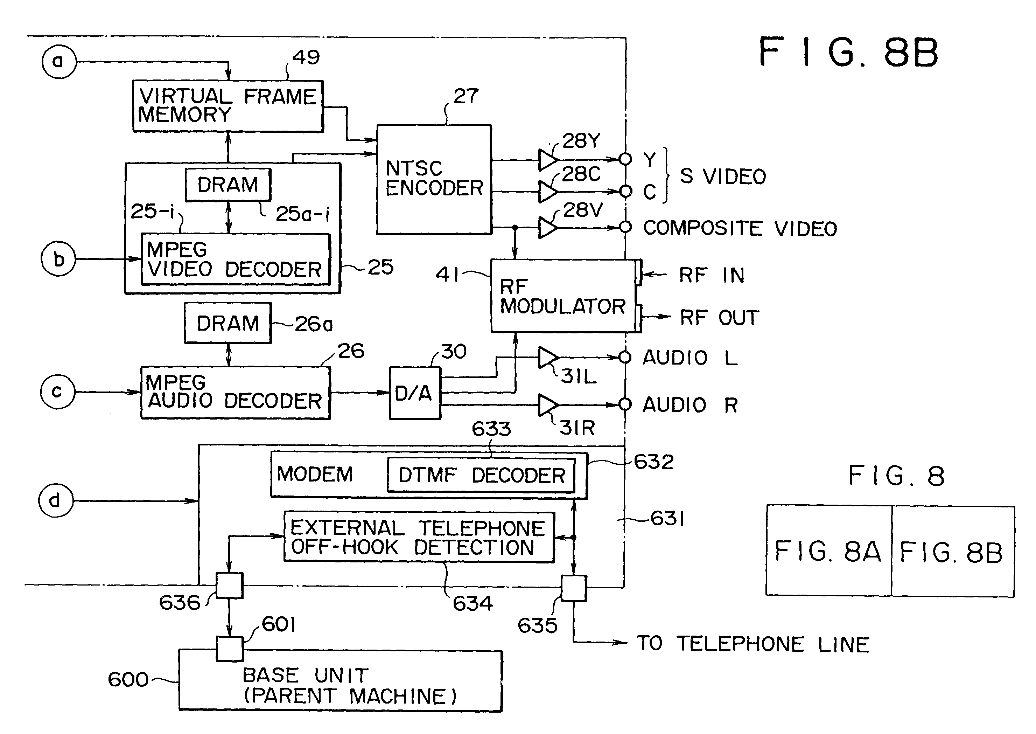

According to the present invention as recited in claim 1, an electronic apparatus to which a program relating information display apparatus is applied and which is remotely controlled by a remote commander includes program reception means (for example, a tuner 21 in FIG. 8) for receiving a program and character information relating to the program transmitted thereto over a channel, and character information transmission means (for example, an IR transmission section 660 in FIG. 8) for transmitting the character information to the remote commander in order to cause the remote commander to display the character information.

According to the present invention as recited in claim 3, the electronic apparatus to which a program relating information display apparatus is applied further includes control signal reception means (for example, an IR reception section 659 in FIG. 8) for receiving a control signal relating to the transmitted character information from the remote commander.

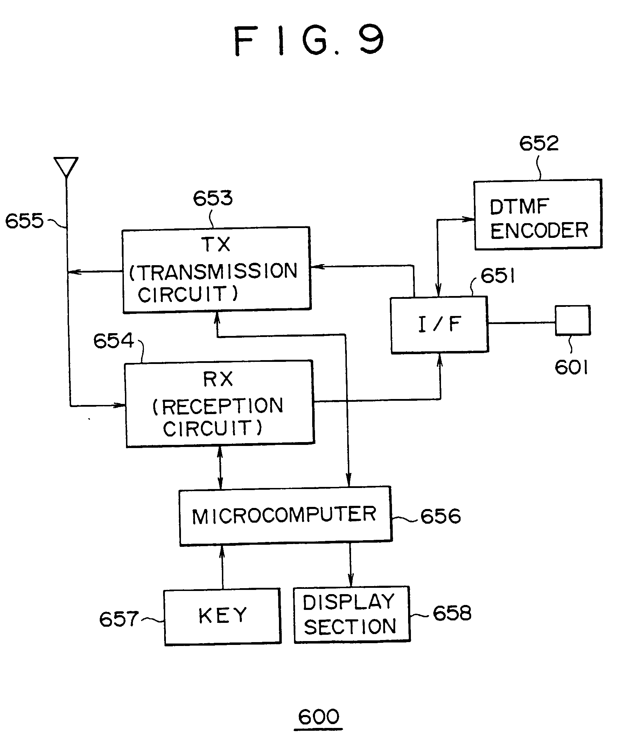

According to the present invention as recited in claim 5, the electronic apparatus to which a program relating information display apparatus is applied is constructed such that the remote commander serves also as a cordless telephone set, and the electronic apparatus further includes communication means (for example, a transmission circuit 653 and a reception circuit 654 in FIG. 9) for communicating transmission speech and reception speech with the cordless telephone set.

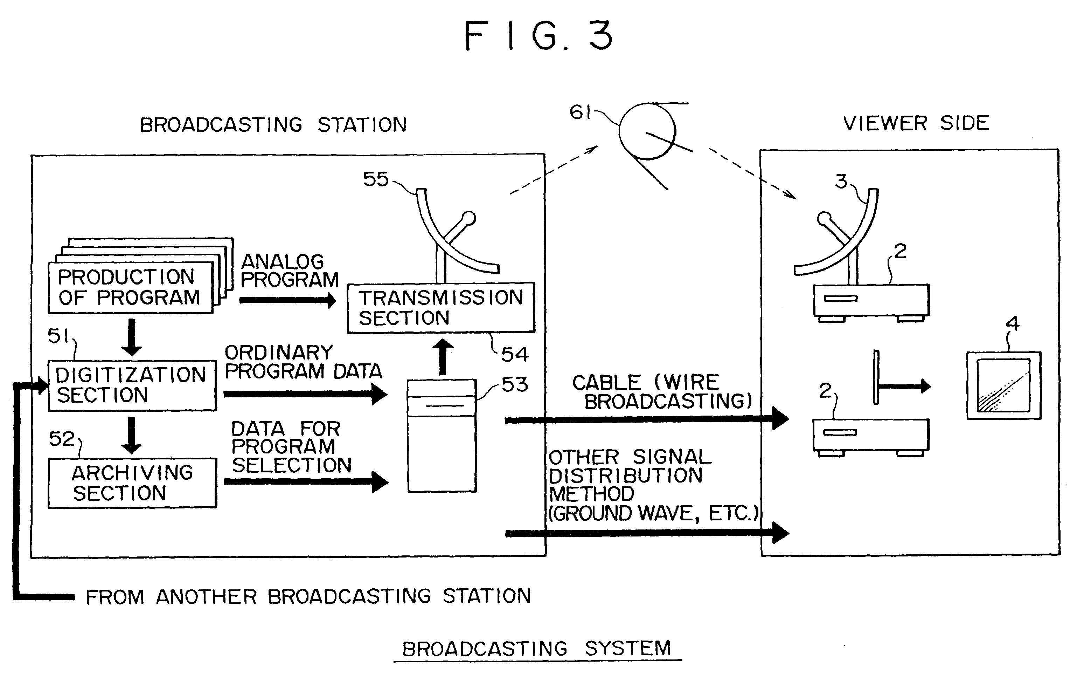

According to the present invention as recited in claim 7, the electronic apparatus to which a program relating information display apparatus is applied further includes display means (for example, a monitor apparatus 4 in FIG. 3) for displaying the program.

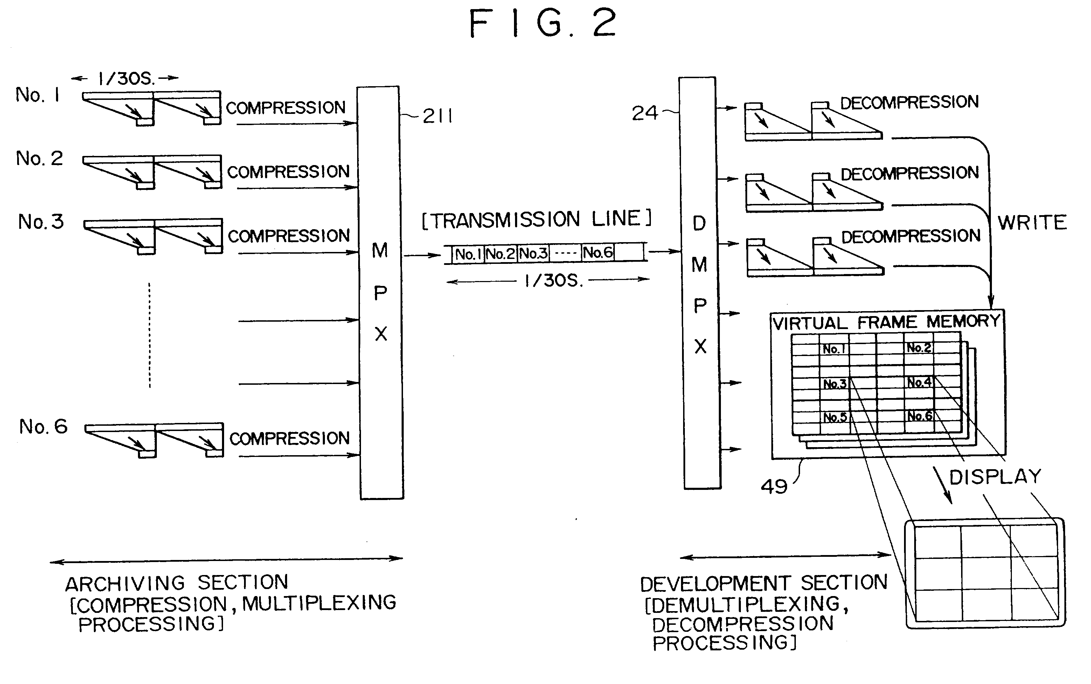

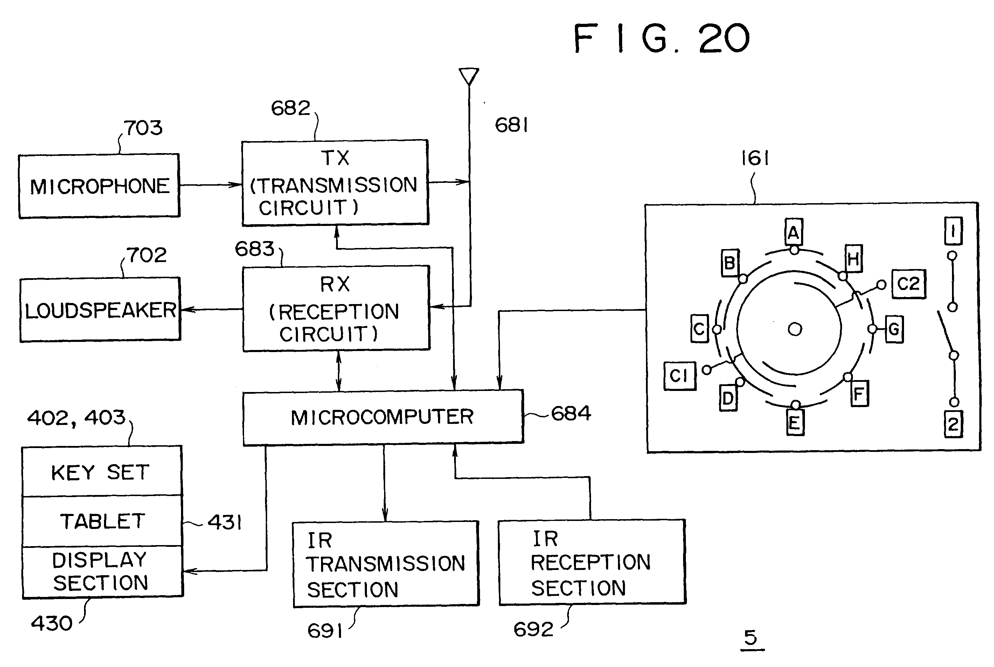

According to the present invention as recited in claim 9, a remote commander to which a program relating information display apparatus is applied and which remotely controls an electronic apparatus which receives a program transmitted thereto over a channel includes character information reception means (for example, an IR reception section 692 of FIG. 2) for receiving character information relating to the program transmitted thereto from the electronic apparatus, and display means (for example, a display section 430 of FIG. 20) for displaying the character information received by the character information reception means.

According to the present invention as recited in claim 10, the remote commander to which a program relating information display apparatus is applied further includes generation means (for example, a microcomputer 684 in FIG. 20) for generating, while the character information received by the character information reception means is displayed on the display means, a control signal relating to the character information.

According to the present invention as recited in claim 11, the remote commander to which a program relating information display apparatus is applied further includes communication means (for example, a transmission circuit 682 and a reception circuit 683 in FIG. 20) for communicating transmission speech and reception speech with the electronic apparatus.

According to the present invention as recited in claim 12, the remote commander to which a program relating information display apparatus is applied further includes call origination means (for example, a microcomputer 684 in FIG. 20) for performing, when a key is operated while a telephone number is displayed as the character information received by the character information reception means on the display means, a call origination operation to the telephone number.

It is to be noted that naturally the present invention is not limited to the specific means described above.

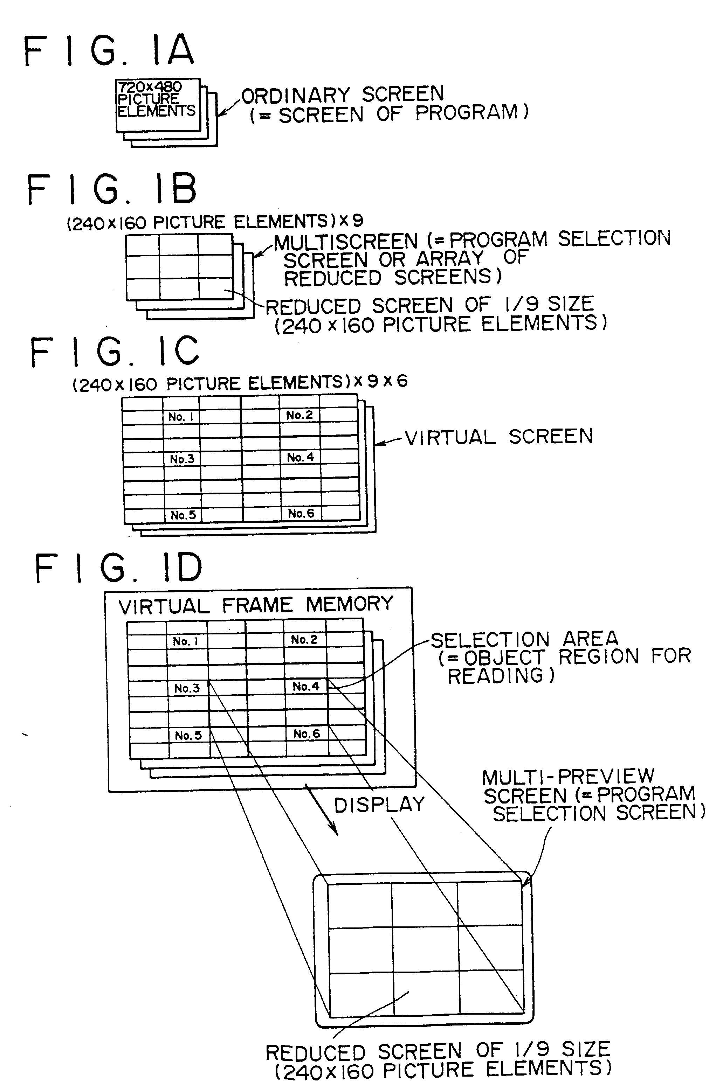

FIGS. 1A to 1D illustrate definitions of several terms used in the present specification. FIG. 1A shows an ordinary screen (screen of a program) which signifies a screen on which an original image is displayed in full motion of the frame rate of 30 frames/second (30 fps) in the full size (720 x 480 picture elements).

FIG. 1B shows a multi-screen (program selection screen or array of reduced screens) which signifies a screen on which nine reduced screens of the 1/9 frame size (240 x 160 picture elements) are arranged in a 3x3 matrix. Each of the reduced screens is a screen displayed in full motion (30 fps).

FIG. 1C shows a virtual screen which is an imaginary array screen on which six multi-screens of No. 1 to No. 6 are arranged in a 2x3 matrix. The virtual screen is successively written into a virtual frame memory at timings which satisfy the frame rate of 30 fps. Each reduced screen has the 1/9 frame size (240 x 160 picture elements) and is written so that it may be displayed in full motion (30 fps).

FIG. 1D shows a selection area (area from which data are to be read out) for selecting a multi-screen to be read out from within a virtual screen written in the virtual frame memory in response to a cursor moving operation. The selection area is moved upwardly or downwardly or leftwardly or rightwardly as the cursor moves. When reduced screens are to be displayed in units of a program category or the like, the corresponding reduced screens in the virtual screen are re-arranged on a predetermined child screen.

When an image selected with the selection area is displayed on a monitor apparatus, a multi-preview screen (program selection screen) is displayed. The multi-preview screen is a multi-screen read out from within the virtual screen written in the virtual frame memory in response to a cursor moving operation and displayed on the monitor apparatus. Each of the reduced screens of the multi-preview screen is displayed in full motion (30 fps) in the 1/9 frame size (240 x 160 picture elements).

Prior to description of preferred embodiments of the present invention, archiving processing will be described with reference to FIG. 2.

In particular, in the present invention, a plurality of (nine in the embodiments described below) screens of different programs are individually reduced (compressed) by thinning out (sampling) processing so that each of them includes a number of picture elements equal to one third that of the original screen in each of the vertical direction and the horizontal direction. Consequently, nine reduced screens each reduced to one ninth in area are produced. Then, the nine reduced screens are disposed at different positions of a multi-screen which is divided into 3x3 areas (reduced screens). A plurality of (six in the following embodiment) multi-screens of No. 1 to No. 6, each of which corresponds to one screen (one broadcasting channel), are produced in this manner. Then, as seen in FIG. 2, the six multi-screens of No. 1 to No. 6 are individually compressed by the MPEG system and then multiplexed by a multiplexer 211 so that they may be transmitted by one transmission channel. In the present specification, the compression and multiplexing processing is referred to as archiving processing.

The data multiplexed into data of one transmission channel by the multiplexer 211 are transmitted to the reception side via a transmission line formed from an artificial satellite, a cable, or a like element.

On the reception side, the data of one transmission channel transmitted thereto via the transmission line are demultiplexed by a demultiplexer 24 so that data of six original broadcasting channels (data of the multi-screens of No. 1 to No. 6 each having nine reduced screens) are separated.

Then, the thus demultiplexed data of the multi-screens of No. 1 to No. 6 (data of the program selection screens) are decompressed (decoded) by the MPEG system and stored into a virtual frame memory 49 so that they may construct a large virtual screen.

Then, a region of arbitrary 3x3 reduced screens of the virtual screen is selected suitably and then outputted and displayed.

FIG. 3 shows a broadcasting system to which the present invention is applied. Referring to FIG. 3, a broadcasting station performs broadcasting of a program of, for example, the DSS. In particular, in the broadcasting station, a program or a plurality of programs (analog video and audio signals) of a broadcasting channel or different broadcasting channels are produced and supplied to a digitization section 51. Also programs of other broadcasting stations are supplied to the digitization section 51. The digitization section 51 digitizes the video and audio signals constructing the received programs and outputs the digitized video and audio signals to an archiving section 52.

The archiving section 52 receives, in addition to the programs from the digitization section 51, a digitized program or a plurality of digitized programs (digitized video and audio signals) of a broadcasting channel or different broadcasting channels from another station or stations. The archiving section 52 produces data for program selection (data for a program selection screen) representative of contents of a plurality of programs of different channels inputted thereto for the individual channels. In particular, the archiving section 52 reduces the screens (images) of a plurality of channels inputted thereto and forms an image of a multi-screen with nine reduced screens. Then, for example, programs of nine broadcasting channels are combined into a multi-screen of one broadcasting channel.

Since data for program selection (reduced screens) are produced in this manner using programs broadcast normally as they are, the labor for production of a program for program selection independent of programs broadcast normally can be eliminated.

It is to be noted that it is assumed here that the archiving section 52 produces, for a program of each channel, a program of a screen reduced, for example, to one third in each of the vertical direction and the horizontal direction from that of the screen of the program (accordingly, in terms of the area, a screen reduced to one ninth that of the program of the broadcasting channel). Accordingly, in this instance, on the viewer side, reduced screens of programs of nine broadcasting channels can be displayed at a time on one screen.

Further, the archiving section 52 transmits audio signals of the programs of the individual child screens of the multi-screen (programs received from the digitization section 51 and the other broadcasting stations) together with the reduced screens.

Then, the archiving section 52 compresses the data by the MPEG system.

The archiving section 52 produces a plurality of (for example, 6) such multi-screens (program selection screens) (in other words, reduced screens of totalling 54 (= 6 x 9) programs are produced). Then, the data of the six multi-screens are combined (archived) into data of one transmission channel. Here, data of a plurality of program selection screens outputted from the archiving section 52 and including a combination of programs of a plurality of broadcasting channels into data of one broadcasting channel may be hereinafter referred to as archived data (the terminology "archive" is a computer terminology signifying to combine data of a plurality of files into one file).

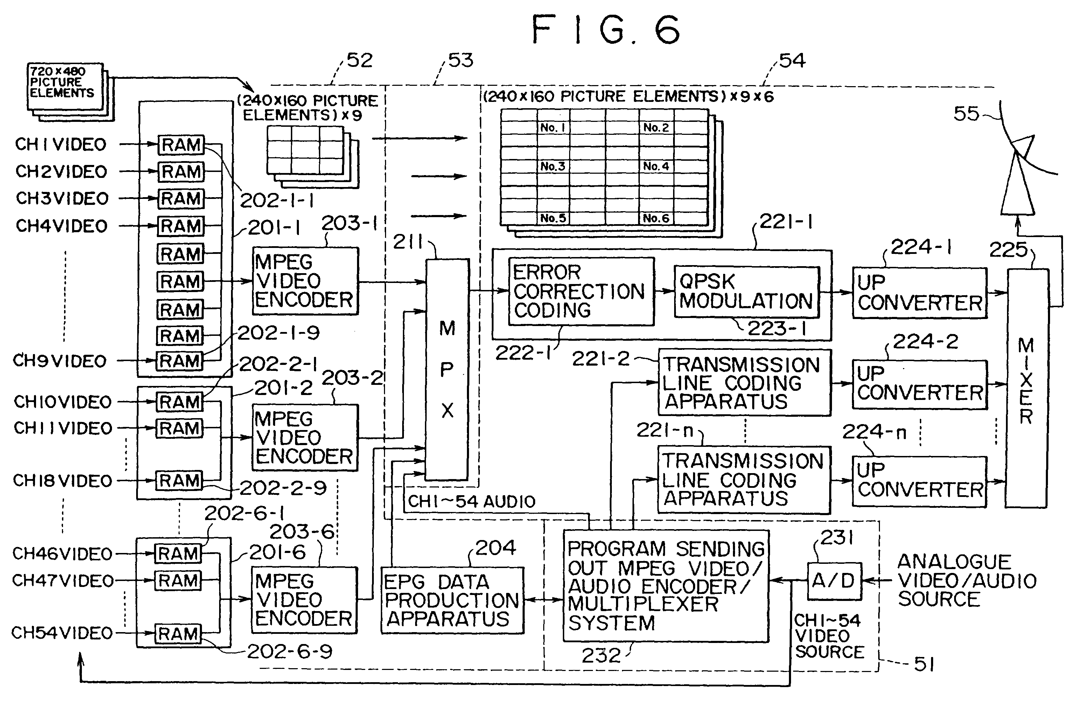

A video server 53 receives the archived data outputted from the archiving section 52 and further receives programs of the plurality of broadcasting channels digitized by the digitization section 51 and compressed by the MPEG system (details will be hereinafter described with reference to FIG. 6).

The video server 53 stores the received data once and supplies them to a transmission section 54.

The transmission section 54 performs error correction processing, modulation (for example, QPSK modulation or the like) processing and other necessary processing (for example, encipherment processing, multiplexing processing, up conversion and so forth) for the data received from the video server 53. Then, a signal obtained as a result of the processing is transmitted to an artificial satellite (BS (broadcasting satellite) or CS (communication satellite)) 61 from a parabola antenna 55 and then transmitted to the viewer side from the artificial satellite 61. In other words, from the transmission section 54, the archived data of the program selection screen are transmitted together with the programs of the plurality of broadcasting channels to the viewer side via the artificial satellite 61. Accordingly, when the screen of each program is considered to be a screen of the full size, the screens of the full size and the reduced screens obtained by reduction of the screens of the full size are transmitted simultaneously from the broadcasting station.

It is to be noted that, while the programs of the plurality of broadcasting channels and the archived data are transmitted to the viewer side via the artificial satellite 61, they may otherwise be transmitted to the viewer side from the video server 53 via a wire transmission line such as a cable or in the form of a ground wave or by some other suitable signal distribution method. Further, the programs of the plurality of channels and the archived data may be transmitted not via a single transmission line but via a plurality of transmission lines to the viewer side (for example, the programs of the plurality of broadcasting channels may be transmitted via the artificial satellite 61 while the archived data are transmitted via a cable).

Furthermore, although the programs of the plurality of broadcasting channels (data of ordinary programs) are transmitted after digitized by the digitization section 51, they may otherwise be supplied to the transmission section 54 while each of them remains in the form of an analog signal (analog program) so that they may be transmitted together with the archived data transmitted thereto from the video server 53.

On the viewer side, the data transmitted from the broadcasting station via the artificial satellite 61 (programs of the plurality of broadcasting channels and archived data) are received by a parabola antenna 3 and supplied to a receiver (set top box) 2.

The receiver 2 performs necessary processing to the data from the parabola antenna 3, and a video signal from the receiver 2 is supplied to and displayed on a monitor apparatus 4 which may be, for example, a television receiver while an audio signal is supplied to and outputted as sound from a loudspeaker not shown. In particular, when the receiver 2 is set so that a particular broadcasting channel is selected, a program of the particular broadcasting channel is displayed on the monitor apparatus 4. On the other hand, when archive data are selected, reduced screens of programs of a predetermined number of broadcasting channels (in the present embodiment, nine channels as described hereinabove) from among a plurality of reduced screens are simultaneously displayed on the monitor apparatus 4. Accordingly, in this instance, the viewer can observe the program selection screen and recognize contents of the programs of the channels being currently broadcast (details will be hereinafter described). The screen for program selection may be hereinafter referred to as preview screen.

It is to be noted that, when data are transmitted from the broadcasting station via a cable or the like, they are directly received by the receiver 2. Further, when data are transmitted via a ground wave or the like from the broadcasting station, they are received by an antenna for ground waves not shown and then supplied to the receiver 2. Further, while two receivers 2 are shown in FIG. 3, data transmitted via the artificial satellite 61 or data transmitted via a cable or by way of a ground wave can be received by only one such receiver 2.

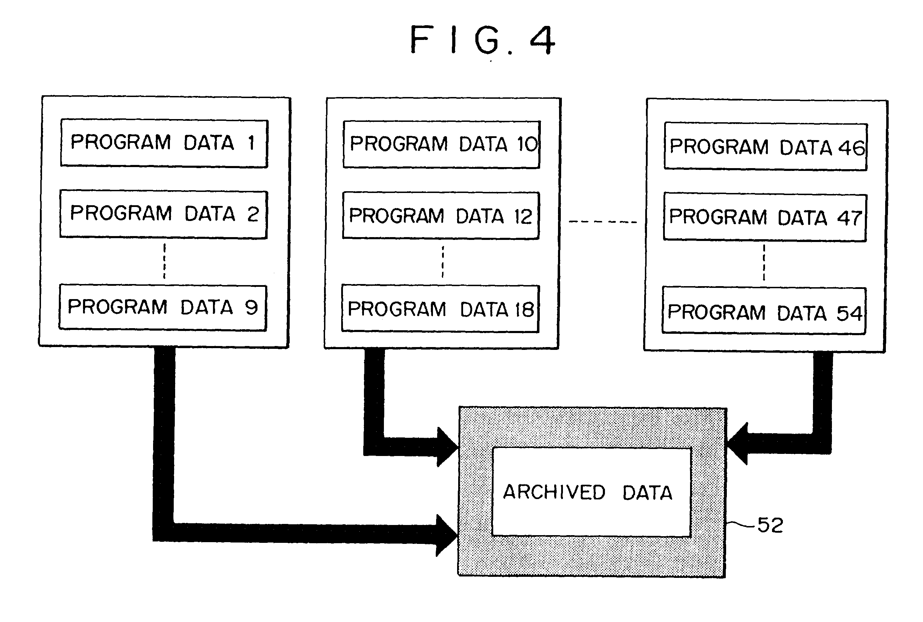

FIG. 4 illustrates a manner in which archive data are produced by the archiving section 52. As seen from FIG. 4, the archiving section 52 reduces nine screens (images) of programs of broadcasting channels to produce a single multi-screen. Data of the single multi-screen can be handled, on the viewer side, as data of a broadcasting channel or independent data for program selection. Then, the archiving section 52 produces six such multi-screens and combines them as data of one transmission channel (archived data).

It is to be noted that the program data illustrated in FIG. 4 include reduced screen data as well as audio signals of individual broadcasting channels as described hereinabove.

Further, the archiving section 52 not only can produce archived data from a plurality of reduced screens of programs of different broadcasting channels and output the archived data to the video server 53, but also can produce archived data from such reduced screens and output the archive data to the video server 53 after the reduced screens are re-arranged into a predetermined array condition such that, for example, they are arranged for individual categories of programs.

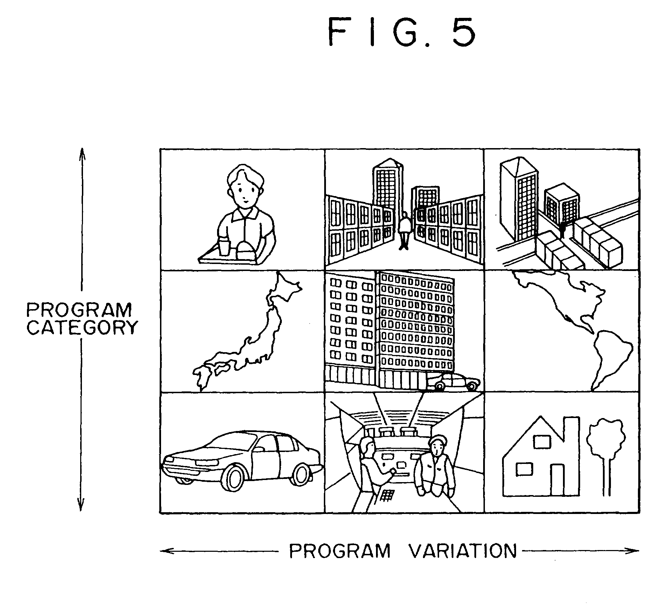

In particular, for example, reduced screens of different categories of programs may be arranged in the vertical direction while reduced screens of same categories of programs are arranged in the horizontal direction as seen in FIG. 5. More particularly, for example, reduced screens of news programs are arranged in the first horizontal row; reduced screens of movie programs are arranged in the second horizontal row; and reduced screens of music programs are arranged in the third horizontal row. Further, in this instance, in each horizontal row, reduced screens of programs of the same category are arranged, for example, in an ascending order of broadcasting channels of the programs or in an alphabetical order of the titles of the programs.

When the number of categories is four or more or when the number of programs of a category is four or more, a program or programs of an excessive number of categories or of an excessive number of programs of a category are arranged in another program selection screen. Then, a single virtual frame is formed of a plurality of (six) program selection screens (this will be hereinafter described).

Where a multi-preview screen in which reduced screens are arranged in such a manner as described above is displayed on the viewer side, the viewer can find out a desired program readily by observing (visually scanning) the multi-preview screen in a horizontal direction along a row of the category of the desired program.

Further, in this instance, if a predetermined cursor 201 is displayed on a predetermined one of the reduced screens forming such a multi-preview screen as seen in FIG. 5 and then moved on the multi-preview screen, then the viewer can find out and select a desired program readily.

Subsequently, production of a program selection screen will be described in more detail with reference to FIG. 6. The digitization section 51 converts a video signal and audio signals inputted thereto from analog signals into digital signals by means of an analog to digital (A/D) converter 231, from which the digital video and audio signals are outputted to a program sending out MPEG video/audio encoder/multiplexer system 232. Of the digital video signal, the video signal for 54 channels is supplied to multi-screen production circuits 201-1 to 201-6 of the archiving section 52. Where the input video and audio signals are supplied as digital signals, the digital signals are supplied as they are directly to the program sending out MPEG video/audio encoder/multiplexer system 232 and the multi-screen production circuits 201-1 to 201-6.

The multi-screen production circuit 201-1 includes nine RAMs 202-1-1 to 202-1-9 into which data of nine screens of different programs inputted to the multi-screen production circuit 201-1 are stored. Then, the data of the nine screens are reduced to 1/3 in the vertical direction and the horizontal direction to produce nine reduced screens. Then, the nine reduced screens are individually distributed to a multi-screen divided into 3 x 3 = 9 areas.

For example, where one screen (one frame) is formed from 720 x 480 picture elements, the numbers of picture elements are reduced to 1/3 in the horizontal direction and the vertical direction, or in other words, picture elements are sampled or thinned out, to produce an image of a reduced picture screen of 240 x 160 picture elements. Then, such images of the reduced screens (3 pieces×3 pieces) are arranged in the horizontal direction and the vertical direction, to produce a multi-screen including nine reduced screens. The multi-screen is formed from 720 x 480 picture elements.

Similar processing is performed for the other five multi-screen production circuits 201-2 to 201-6. As a result, six multi-screens (program selection screens) each including nine reduced screens are produced.

Data of the six multi-screens produced by the multi-screen production circuits 201-1 to 201-6 in this manner are supplied to corresponding MPEG video encoders 203-1 to 203-6, by which they are compressed by the MPEG system, respectively. Consequently, six archive data (for six broadcasting channels) are obtained.

Meanwhile, an EPG (Electrical Program Guide) data production apparatus 204 of the archiving section 52 produces, based on the digital video and audio signals received from the program sending out MPEG video/audio encoder/multiplexer system 232, electronic program guide data (EPG data) of the programs of the 54 broadcasting channels supplied to the multi-screen production circuits 201-1 to 201-6 from the program sending out MPEG video/ audio encoder/multiplexer system 232. It is to be noted that the EPG data includes broadcasting starting times, broadcasting channel numbers, program categories, program names, positions on a multi-screen, and numbers (for example, 240×160 pieces) of picture elements of reduced screens.

The video server 53 stores, in accordance with the necessity, the video data supplied thereto from the MPEG video encoders 203-1 to 203-6 of the archiving section 52 and the EPG data supplied thereto from the EPG data production apparatus 204 into a built-in memory thereof once and then reads out the stored data. Then, a multiplexer of the video server 53 converts the thus read out data into packets and multiplexes (archives) them so that they may be transmitted via one transmission channel (channel corresponding to one transponder). In this instance, also archived audio data of the 54 programs are inputted to the video server 53 from the program sending out MPEG video/audio encoder/multiplexer system 232. Also the audio data are converted into packets and multiplexed so that they may be transmitted via the same transmission channel.

In this manner, the archived data including the six multi-screens (the six multi-screens construct one virtual frame) each including nine reduced screens are supplied as a signal of one transmission channel to a transmission line coding apparatus 221-1 of the transmission section 54.

An error correction coding apparatus 222-1 of the transmission line coding apparatus 221-1 performs error correction coding processing of the data inputted thereto from a multiplexer 211 and outputs the resultant data to a QPSK modulation circuit 223-1. The QPSK modulation circuit 223-1 QPSK-modulates the inputted data and outputs the resultant data to an up converter 224-1. The up converter 224-1 converts the data inputted thereto into a signal of a predetermined frequency band (signal corresponding to a transponder of the artificial satellite) and outputs the resultant data to a mixer 225.

In this manner, the transmission channel for program selection screens is a transmission channel for exclusive use.

In the meantime, the video data and the audio data of the at least 54 programs (programs as screens of the full size) are individually compressed by the MPEG system by the program sending out MPEG video/audio encoder/ multiplexer system 232 and converted into packets so that, for example, programs of each six broadcasting channels may be transmitted by one transmission channel, whereafter they are multiplexed. However, the number of broadcasting programs (broadcasting channels) to be multiplexed varies depending upon the complexity of images of the broadcasting programs.

Then, the data of the one transmission channel are inputted to another transmission line coding apparatus 221-2, by which error correction coding processing and QPSK modulation processing are performed in a similar manner as described above by the transmission line coding apparatus 221-1. Then, data outputted from the transmission line coding apparatus 221-2 are converted into a signal of a predetermined frequency band corresponding to another transponder of the artificial satellite by another up converter 224-2 and then inputted to the mixer 225.

Data obtained by similar processing by further transmission line coding apparatus 221-3 to 221-n and up converters 224-3 (not shown) to 224-n are inputted to the mixer 225.

The mixer 225 mixes the data inputted thereto from the up converter 224-1 to 224-n and transmits resultant data to the artificial satellite 61 by means of the parabola antenna 55.

By the way, the system may be constructed so as to make it possible to display, on the viewer side, the numbers of broadcasting channels together with a plurality of reduced screens as a multi-preview screen so that the viewer may select the broadcasting channel of a desired program by inputting the number of the broadcasting channel. In this instance, however, it may possibly occur that, for example, the viewer may mistake the broadcasting channel or may manually input a wrong number different from that corresponding to the intended broadcasting channel. Therefore, after such a preview screen as seen in FIG. 5 is displayed, it is desirable to display a parent screen of a desired program in response to direct selection of a reduced screen corresponding to the program.

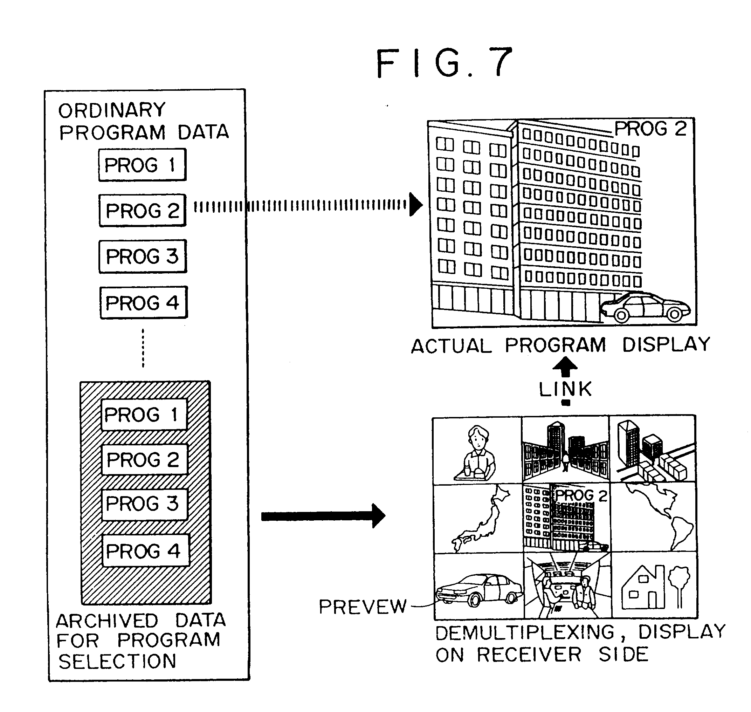

To this end, a link is provided between each reduced screen and a corresponding program. In particular, for example, the archiving section 52 adds, to data of each reduced screen, the number of a broadcasting channel of a program corresponding to the reduced screen and transmits the number of the broadcasting channel as EPG data. Consequently, when a reduced screen forming a multi-preview screen is selected as seen in FIG. 7, a program linked to the reduced screen, that is, a screen (program) of the full size corresponding to the selected reduced screen, can be displayed. It is to be noted that FIG. 7 illustrates a manner wherein one of nine reduced screens forming a multi-preview screen which is disposed at the center is selected, and consequently, in FIG. 7, a program PROG2 corresponding to the selected reduced screen is shown displayed in place of the multi-preview screen.

FIG. 8 shows an example of an internal construction of the receiver 2 for receiving the DSS described hereinabove. An RF signal outputted from a low noise block downconverter (LNB) 3a of the parabola antenna 3 is supplied to and demodulated by a tuner 21 of a front end circuit 20. The output of the tuner 21 is supplied to a QPSK demodulation circuit 22, by which it is QPSK demodulated. The output of the QPSK demodulation circuit 22 is supplied to an error correction circuit 23, by which errors are detected and corrected.

A CAM (Conditional Access Module) 33 formed of, for example, an IC card including a CPU, a ROM, a RAM and so forth stores keys necessary for decipherment of a cipher together with a decipherment program. When a broadcasting station transmits data to which encipherment processing has performed, keys and decipherment processing are required to decipher the cipher. Therefore, the keys are read out from the CAM 33 via a card reader interface 32 and supplied to the demultiplexer 24. The demultiplexer 24 deciphers the enciphered signal using the keys.

It is to be noted that the CAM 33 stores, in addition to the keys and the decipherment program necessary for decipherment of a cipher, accounting information.

The demultiplexer 24 receives, as an input thereto, a signal outputted from the error correction circuit 23 of the front end circuit 20 and stores the received signal into a data buffer memory (SRAM: Static Random Access Memory) 35 once. Then, the signal is read out suitably and used for decipherment as described above. Then, when the result of the decipherment is ordinary program data, the demultiplexer 24 supplies image data or audio data forming the program data to a multi-channel real time decoder 25 or an MPEG audio decoder 26. The EPG data are stored into a predetermined area of the data buffer memory 35.

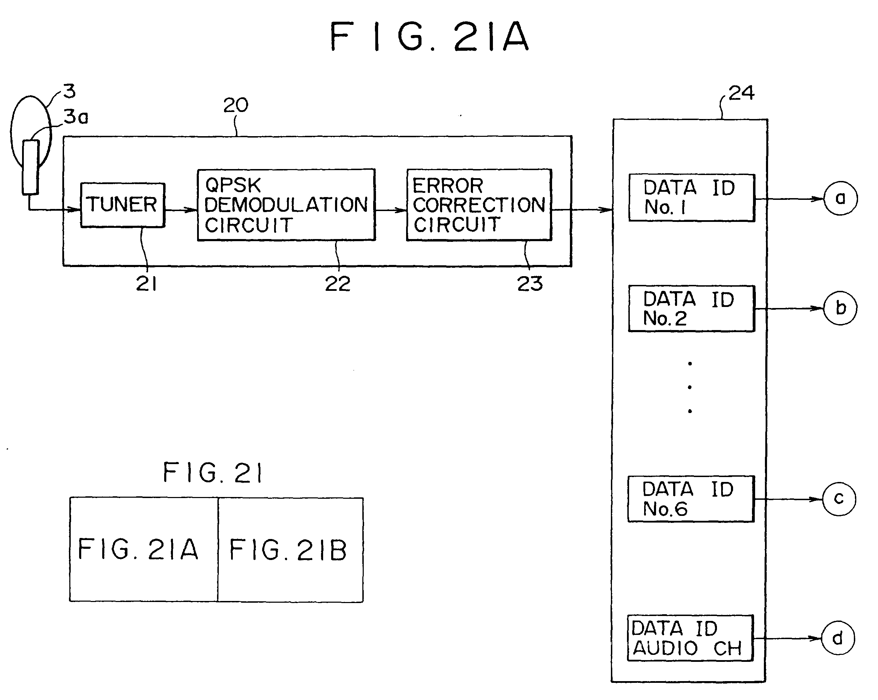

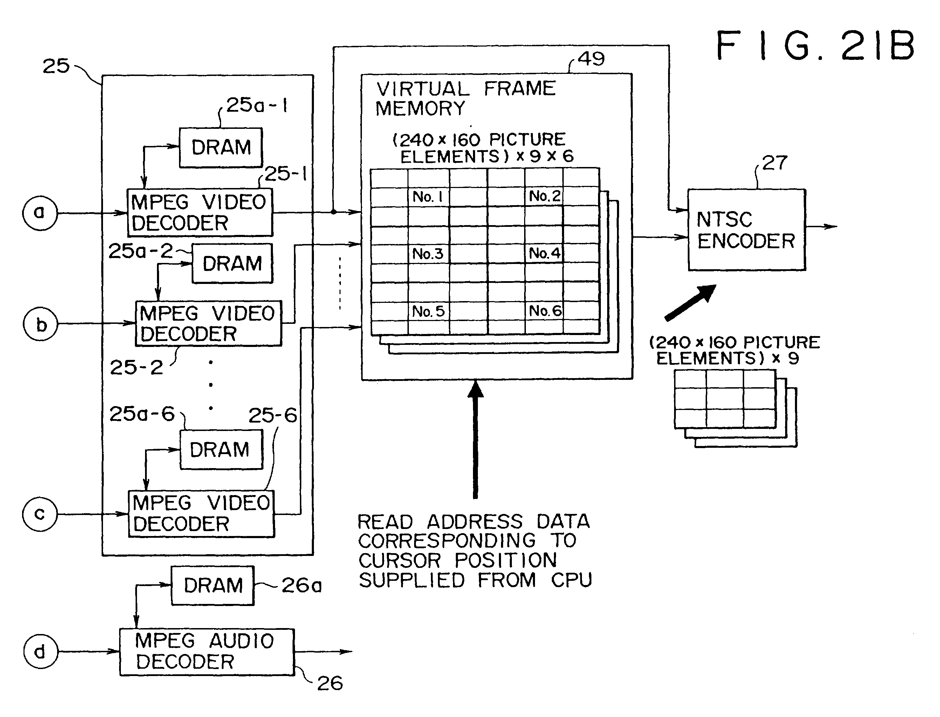

The multi-channel real time decoder 25 includes built-in MPEG video decoders 25-1 to 25-6 and DRAMs 25a-1 to 25a-6 in order that screen data of programs of six broadcasting channels can be decoded as hereinafter described with reference to FIG. 21. The multi-channel real time decoder 25 thus stores image data (digital image data) inputted thereto suitably into the DRAMs 25a-1 to 25a-6 and executes decoding processing of the video signals in a condition compressed by the MPEG system.

The decoded video data are supplied, when they are data of an ordinary program, to an NTSC encoder 27, by which they are converted into a luminance signal (Y), a chroma signal (C) and a composite signal (V) of the NTSC system. The lumiance signal and the chroma signal are outputted individually as S video signals via a pair of buffer amplifiers 28Y and 28C, respectively. The composite signal is outputted via a further buffer amplifier 28V.

Meanwhile, video data of a multi-screen screen are supplied to and stored into the virtual frame memory 49. Then, predetermined nine reduced screens are read out in accordance with the necessity and supplied to the NTSC encoder 27.

It is to be noted that an MPEG 2 decoding LSI (STi3500) by SGS-Thomson Microelectronics can be used for the MPEG video decoders 25-i of FIG. 21. An outline of the product is presented, for example, by Martin Bolton, in Nikkei Electronics, Nikkei PB Company, No. 603, March 14, 1994, pp.101-110.

Meanwhile, a transport stream of the MPEG2 (MPEG2-Transportstream) is described in Newest MPEG Textbook, ASCII, August 1, 1994, pp.231-253.

The MPEG audio decoder 26 suitably stores the digital audio signals supplied thereto from the demultiplexer 24 into a DRAM 26a and executes decoding processing of the audio data in a condition compressed by the MPEG system. The thus decoded audio data are converted from digital signals into analog signals by a digital to analog (D/A) converter 30, and the audio signal of the left channel is outputted via a buffer amplifier 31L while the audio signal of the right channel is outputted via a buffer amplifier 31R.

An RF modulator 41 converts the composite signal outputted from the NTSC encoder 27 and the audio signals outputted from the digital to analog converter 30 into a RF signal and outputs the RF signal. Further, when a TV mode in which a television broadcasting signal by a ground wave is to be received is set, the RF modulator 41 passes therethrough a RF signal of the NTSC signal inputted thereto from an AV apparatus (not shown) such as a cable box so that the RF signal is outputted as it is to a VCR (VTR) (not shown) or another AV apparatus (not shown).

In the present embodiment, the video signal and the audio signals are supplied to the monitor apparatus 4 via the AV line 11.

A CPU (Central Processor Unit) 29 executes various processes in accordance with a program stored in a ROM 37. For example, the CPU 29 controls the tuner 21, the QPSK demodulation circuit 22, the error correction circuit 23, the virtual frame memory 49 and so forth. Further, the CPU 29 controls the AV apparatus control signal communication section 2A and outputs a predetermined control signal to another AV apparatus (in the present embodiment, the monitor apparatus 4) or receives a control signal from such another AV apparatus.

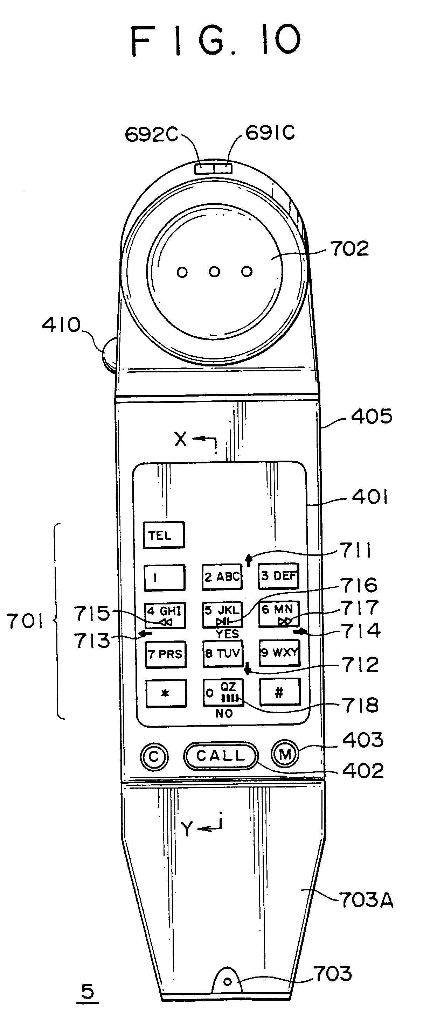

A predetermined instruction can be inputted directly to the CPU 29 by manually operating any of operation buttons and switches (not shown) provided on a front panel 40 of the receiver 2 and can be inputted also by manually operating a cordless telephone set (child machine) 5 shown in FIG. 10 which has a function as a remote commander.

In particular, if a key of the cordless telephone set (child machine) 5 in its remote control mode (without manually operating a TEL key in FIG. 10) is manually operated, then an infrared ray (IR) signal is emitted from an IR transmission section 691 (FIG. 20) of the cordless telephone set (chile machine) 5 and received by an IR reception section 659. An output of the IR reception section 659 is supplied to the CPU 29.

A modem unit 631 connected to the CPU 29 includes a modem 632 having a built-in DTMF decoder 633. The modem 632 is connected to a telephone line via a modular jack 635 and connected to another modular jack 636 via an external telephone off-hook detection circuit 634.

When a signal supplied from the front end circuit 20 is EPG data, the demultiplexer 24 supplies and stores the EPG data to and into the data buffer memory 35.

Data which are desired to be maintained even after disconnection of the power supply, for example, a reception program history of the tuner 21 for four weeks and the number of a channel (last channel) which has been received immediately before disconnection of the power supply are stored suitably into an EEPROM (Electrically Erasable Programmable Read Only Memory) 38. Then, for example, when the power source is connected subsequently, the same channel as the last channel is received again. However, if no last channel is stored, then a channel stored as a default channel in the ROM 37 is received.

Further, when a sleep mode is set, even if the power source is in a disconnected condition, the CPU 29 keeps minimum necessary circuits such as the front end circuit 20, the demultiplexer 24 and the data buffer memory 35 in an operative condition, and besides counts the current time from time information included in a received signal and also performs such control as to cause a required circuit to perform a predetermined operation at a required time (such as timer picture recording). For example, the CPU 29 executes automatic timer picture recording of a reserved program in cooperation with an external VCR.

Further, when the CPU 29 tries to produce predetermined OSD (On-Screen Display) data, it controls the MPEG video decoders 25-i. Under the control of the CPU 29, the MPEG video decoders 25-i produce predetermined OSD data and write the OSD data into OSD areas of the DRAMs 25a-i, whereafter they read out and output the OSD data. Consequently, predetermined characters, a predetermined graphic form (for example, a cursor, a broadcasting channel of a program being currently outputted from the receiver 2, or a bar whose length varies in response to the sound volume) or the like can be suitably outputted to the monitor apparatus 4 so that it may be displayed on the monitor apparatus 4.

FIG. 9 shows an example of a construction of a base unit (telephone parent machine) 600. A modular jack 601 is connected to a line interface (I/F) 651. Also a DTMF encoder 652 is connected to the line interface 651. The DTMF encoder 652 encodes a command inputted thereto into a DTMF signal and outputs the DTMF signal.

The line interface 651 outputs a signal to be transmitted to the child machine 5 to a transmission circuit (TX) 653. The transmission circuit 653 converts the transmission signal into a digital signal, modulates the digital signal and outputs the modulated signal as a RF signal from an antenna 655. A reception circuit (RX) 654 receives and demodulates the RF signal transmitted thereto from the child machine 5 via the antenna 655, and outputs an audio signal to the line interface 651 and outputs a command to a microcomputer 656.

The microcomputer 656 which includes a CPU, a ROM, a RAM and so forth (not shown) built therein controls the transmission circuit 653 and the reception circuit 654 in response to an input from a key 657. Further, a predetermined character or characters, a symbol or symbols and so forth are displayed on a display section 658.

It is to be noted that, for the convenience of illustration and description, a microphone and a loudspeaker are omitted in FIG. 9.

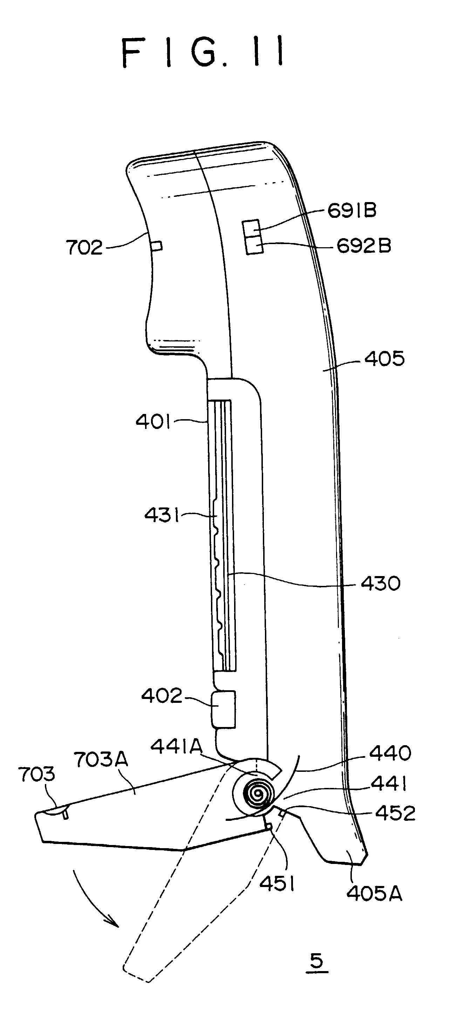

Subsequently, the cordless telephone set (child machine) 5 will be described. FIG. 10 is a front elevational view of the cordless telephone set (child machine) 5, and FIG. 11 is a sectional view taken along line X-Y of FIG. 10 showing the cordless telephone set (child machine) 5. Referring to FIGS. 10 and 11, the cordless telephone set (child machine) 5 shown has a general profile imitating a penguin and is basically composed of a telephone body 405 and a microphone unit 703A (which will be hereinafter described) mounted for pivotal motion on the telephone body 405.

The telephone body 405 includes a loudspeaker 702 located at an upper portion thereof for outputting speech of a counterpart of communication, a display apparatus 401 (display means, which will be hereinafter described in detail) for displaying a channel key, a telephone number and so forth (in FIG. 10, a key set 701 (which will be hereinafter described) is shown displayed), a call button 402 for being manually operated to dial a telephone number displayed on the display apparatus 401 or a like case, a memory button 403 for being manually operated to store information of a telephone number or the like into a memory, and a joystick 410 (operation means) (details of which will be hereinafter described) for being manually operated to move a cursor displayed on the monitor apparatus 4 or a like case.

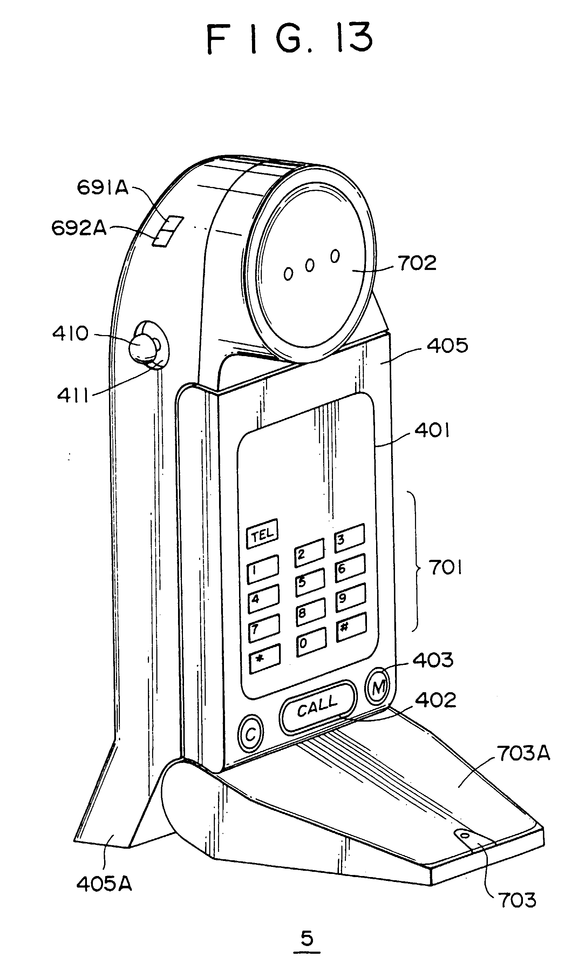

The cordless telephone set (child machine) 5 includes an antenna 681 (FIG. 20) and transmits and receives radio waves to and from the base unit 600 (receiver 2). IR transmission sections 691 for transmitting an IR signal and IR reception sections 692 for receiving an IR signal (691C and 692C in FIG. 10, 691B and 692B in FIG. 11 and 691A and 692A in FIG. 13) are provided in pair on an upper face (FIG. 10), a right side face (FIG. 11) and a left side face (FIG. 13) of the telephone body 405 in the proximity of the loudspeaker 702, respectively.

The receiver 2 is normally placed in front of a user. Therefore, the IR transmission section 691C and the IR reception section 692C (FIG. 10) are located on the cordless telephone set (child machine) 5 such that, when the cordless telephone set (child machine) 5 is used in a horizontal position by a user, they may transmit and receive an IR signal well, respectively. Meanwhile, the IR transmission section 691B and the IR reception section 692B (FIG. 11) are located on the cordless telephone set (child machine) 5 such that, when the cordless telephone set (child machine) 5 is held by the left hand for communication, they may transmit and receive an IR signal well, respectively. Similarly, the IR transmission section 691A and the IR reception section 692A (FIG. 13) are located on the cordless telephone set (child machine) 5 such that, when the cordless telephone set (child machine) 5 is held by the right hand for communication, they may transmit and receive an IR signal well, respectively.

The cordless telephone set (child machine) 5 has formed on a lower portion of the rear face of the telephone body 405 thereof a leg portion 405A which cooperates with the microphone unit 703A to support the telephone body 405 when the cordless telephone set (child machine) 5 is placed on a desk or the like, and a stopper portion 441 for limiting pivotal motion of the microphone unit 703A in the counterclockwise direction in FIG. 11 is formed at a lower portion of the front face of the telephone body 405. Further, a shaft portion 441A serving as a pivot shaft for the microphone unit 703A is formed at an end of the stopper portion 441. Furthermore, a contact portion 452 (which will be hereinafter described) serving as a power supply switch for the cordless telephone set (child machine) 5 is located on the bottom face of the stopper portion 441.

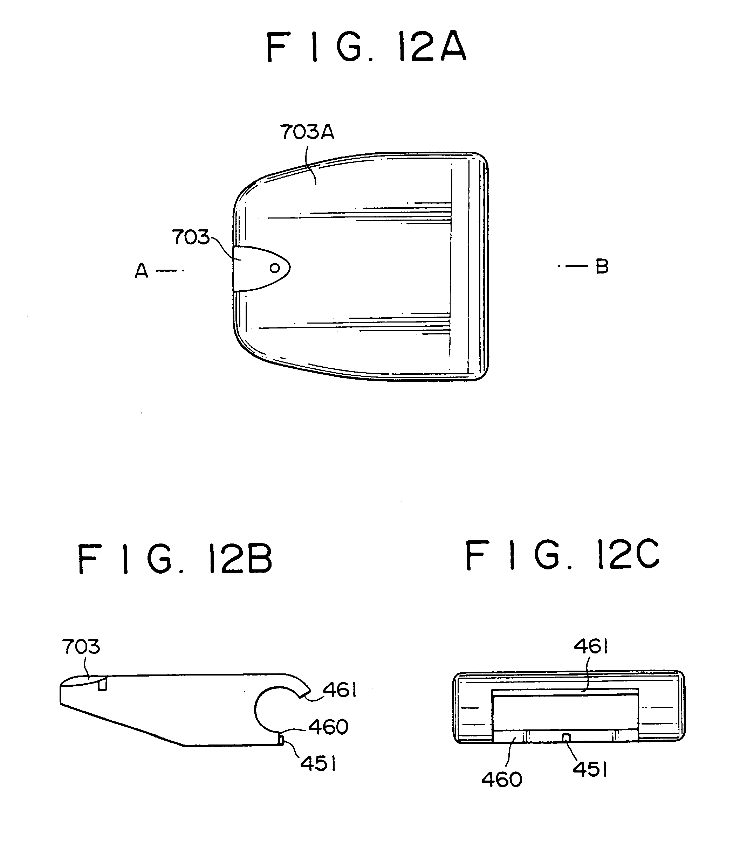

FIGS. 12A to 12C show a detailed construction of the microphone unit 703A shown in FIGS. 10 and 11. In particular, FIG. 12A is a plan view of the microphone unit 703A, FIG. 12B is a sectional view of the microphone unit 703A taken along line A-B of FIG. 12A and FIG. 12C is a rear elevational view of the microphone unit 703A. Referring to FIGS. 12A to 12C, a microphone 703 for collecting speech of a user is located at a central portion of an end (left end in FIGS. 12A and 12B) of the microphone unit 703A, and an end of the microphone unit 703A remote from the microphone 703 is scooped out cylindrically as seen in FIG. 12B such that the shaft portion 441A formed on the telephone body 405 may be fitted in the scooped out recess. Accordingly, the microphone unit 703A is supported for pivotal motion around an axis of the shaft portion 441A.

A pair of angular portions 460 and 461 for limiting pivotal motion of the microphone unit 703A in the clockwise direction and the counterclockwise direction in FIG. 11 are formed on the microphone unit 703A, respectively. The angular portion 460 or 461 contacts with a lower face or an upper face of the stopper portion 441 formed on the telephone body 405 to limit pivotal motion of the microphone unit 703A. A spring 440 shown in FIG. 11 normally biases the microphone unit 703A in the counterclockwise direction in FIG. 11 to that, when the cordless telephone set (child machine) 5 is not placed on a table (when the cordless telephone set (child machine) 5 is held up), the microphone unit 703A is located at a position indicated by a broken line in FIG. 11.

A contact portion 451 serving as a power supply switch for the cordless telephone set (child machine) 5 is located at a predetermined position on the angular portion 460, that is, a position corresponding to the contact portion 452 located on the stopper portion 441, (as seen in FIG. 12C, in the present embodiment, a central position). Consequently, when the microphone unit 703A is pivoted to a position indicated by a broken line in FIG. 11 (that is, when the cordless telephone set (child machine) 5 is held up), the contact portion 451 is brought into contact with the contact portion 452 located at the lower portion of the stopper portion 441 described above so that power supply for the cordless telephone set (child machine) 5 is made available. On the other hand, when the microphone unit 703A is pivoted to another position indicated by a solid line in FIG. 11 (that is, when the cordless telephone set (child machine) 5 is placed on a table), the contact portion 451 is brought out of contact with the contact portion 452 so that power supply to the cordless telephone set (child machine) 5 is interrupted.

FIG. 13 is a perspective view of the cordless telephone set (child machine) 5 when it is placed on a table (that is, when the cordless telephone set (child machine) 5 is not in use). In this instance, the microphone unit 703A is pivoted in the counterclockwise direction in FIG. 13 around the axis of the shaft portion 441A against the biasing force of the spring 440 until the angular portion 461 contacts with the upper face of the stopper portion 441. Accordingly, the cordless telephone set (child machine) 5 is supported by the microphone unit 703A and the leg portion 405A and stands by itself. In this instance, since the contact portion 452 located on the lower face of the stopper portion 441 and the contact portion 451 located on the angular portion 460 do not contact with each other. the power supply to the cordless telephone set (child machine) 5 is not available.

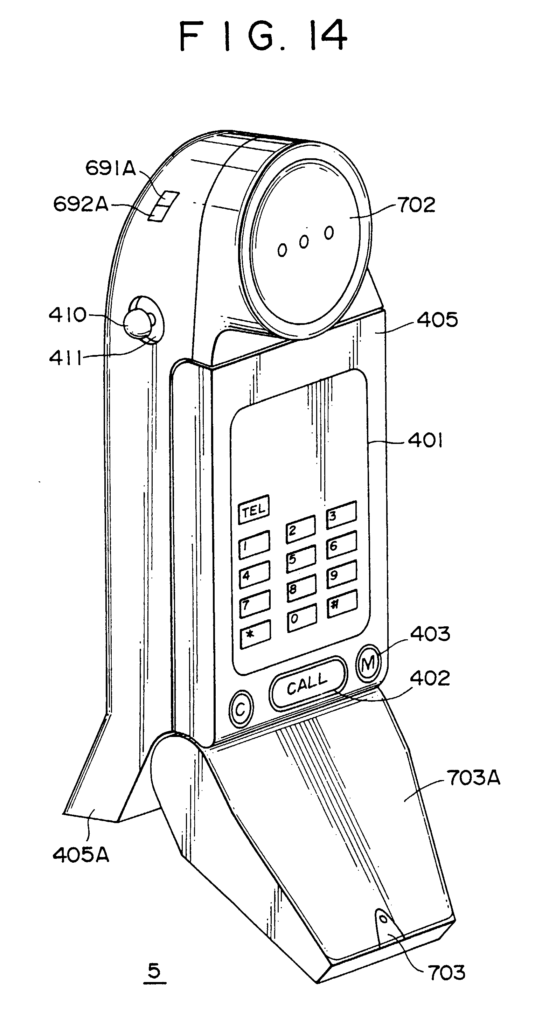

FIG. 14 is a perspective view of the cordless telephone set (child machine) 5 when it is held up by a user (that is, when the cordless telephone set (child machine) 5 is in use). In this instance, since the cordless telephone set (child machine) 5 is not placed on a table, the microphone unit 703A is pivoted in the clockwise direction in FIG. 14 by the biasing force of the spring 440 until the angular portion 460 contacts with the lower face of the stopper portion 441. In this instance, since the contact portion 452 located on the lower face of the stopper portion 441 and the contact portion 451 located on the angular portion 460 contact with each other, the power supply to the cordless telephone set (child machine) 5 is available.

Referring to FIG. 11, the display apparatus 401 includes a display section 430 formed of a liquid crystal display (LCD) unit for displaying information, and a transparent tablet 431 which covers over the display section 430. Further, in order to facilitate, when the key set 701 shown in FIG. 10 is displayed on the display section 430, depression of keys by a user, portions of the tablet 431 corresponding to the positions of the keys are formed in a projecting condition.

The key set 701 includes, in the arrangement shown in FIG. 10, keys on which numerals 0 to 9 are indicated, keys on which the marks * and # are indicated, and an additional key on which the characters TEL are indicated.

Further, the characters ABC are indicated on the key of the numeral 2; DEF on the key of the numeral 3; GHI on the key of the numeral 4; JKL on the key of the numeral 5; MN on the key of the numeral 6; PRS on the key of the numeral 7; TUV on the key of the numeral 8; WXY on the key of the numeral 9; and QZ on the key of the numeral 0.

Further, a rewinding mark 715 symbolizing rewinding of a reproduction point is indicated on the key of the numeral 4; a pause mark 716 symbolizing pause of reproduction is indicated on the key of the numeral 5; and a fast feeding mark 717 symbolizing fast feeding of a reproduction point is indicated on the key of the numeral 6.

Further, a mark 718 symbolizing a function of calling a program selection screen (multi-screen) is indicted on the key of the numeral 0.

Further, as marks symbolizing a movement of a cursor, an arrow mark 711 directed upwardly is indicated in the proximity of the numeral 2 key; another arrow mark 712 directed downwardly is indicated in the proximity of the numeral 8 key; a further arrow mark 713 directed leftwardly is indicated in the proximity of the numeral 4 key; and a still further arrow mark 714 directed rightwardly is indicated in the proximity of the numeral 6 key.

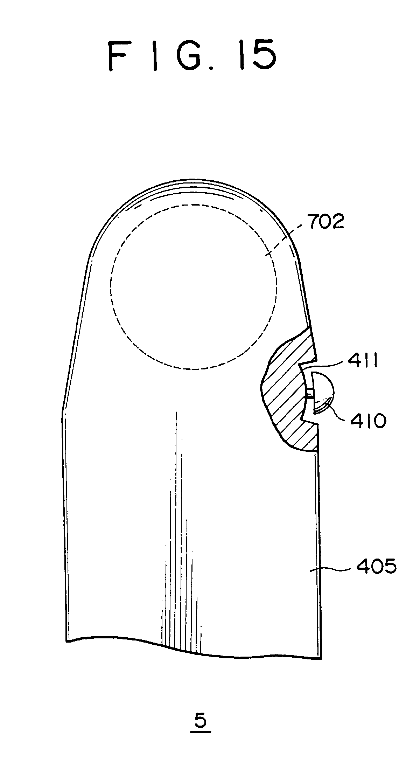

FIG. 15 is a rear elevational view of an upper portion of the telephone body 405 with a portion around the joystick 410 broken. The joystick 410 is located on a right side face of the telephone body 405 as viewed from the rear (on a left side face when the telephone body 405 is viewed from the front) in the proximity of a lower end portion of the loudspeaker 702. A recess 411 is formed on the telephone body 405 so as to allow the joystick 410 to be moved in various directions (8 directions) by a user (though not shown in FIG. 15, the recess 411 is covered so that dust or a foreign particle may not be admitted into it).

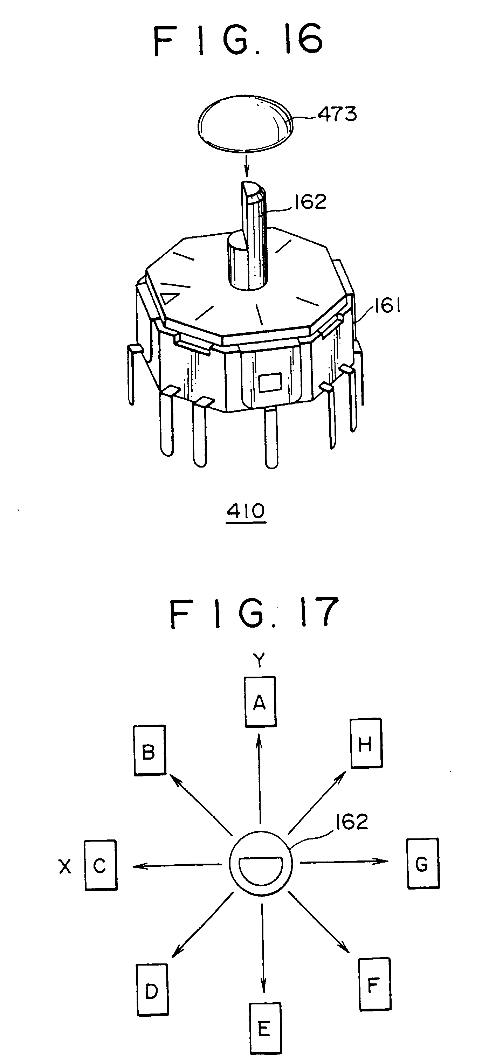

FIG. 16 shows an example of a construction of the joystick 410. The joystick 410 shown includes a body 161, a lever 162 extending from the body 161, and a semispherical operation ball 473 mounted at an end of the lever 162 for being manually operated by a finger of a user. When the operation ball 473 is manually operated in any one of various (eight) directions in a horizontal plane, the lever 162 is turned corresponding to the operation direction, but when the operation ball 473 is manually operated for selection (manually operated vertically), the lever 162 is pushed down in the vertical direction.

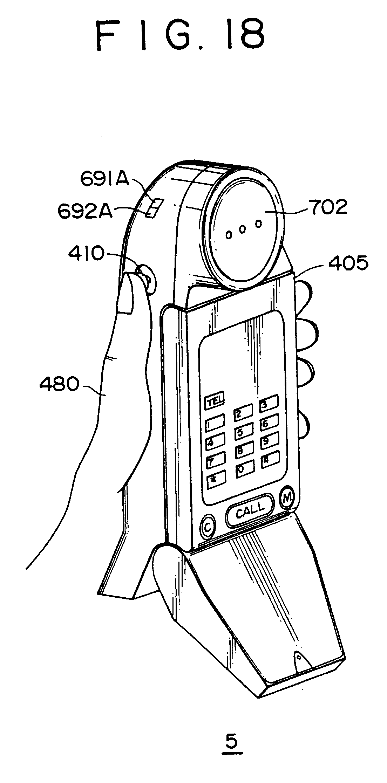

FIG. 17 shows the eight operation directions of the lever 162 in the horizontal plane. As seen in FIG. 17, the lever 162 is constructed so that it can be manually operated in any one of the eight directions denoted by A to H in the horizontal plane.

In the present embodiment, since the joystick 410 is located in the proximity of the lower end of the loudspeaker 702 on a side face of the telephone body 405 (on the left side face of the telephone body 405 as viewed from the front), even when the cordless telephone set (child machine) 5 is in a communication condition, a user can manually operate the joystick 410 readily with a suitable finger of the hand holding the telephone body 405 to perform remote control.

For example, when the user communicates holding the telephone body 405 in the left hand as seen in FIG. 18 (that is, when the user listens to speech outputted from the loudspeaker 702 with the left ear), the user can manually operate the joystick 410 with the thumb 480 of the left hand to perform remote control. In this instance, the IR transmission section 691B and the IR reception section 692B are opposed to the receiver 2 placed in front of the user.

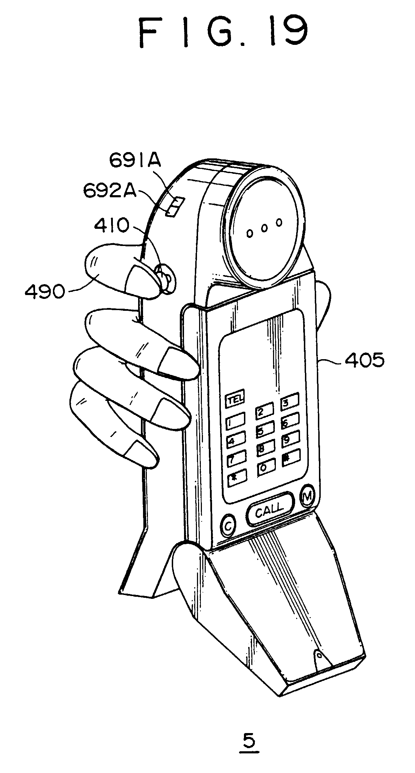

On the hand, when the user communicates holding the telephone body 405 in the right hand as seen in FIG. 19 (that is, when the user listens to speech outputted from the loudspeaker 702 with the right ear), the user can manually operate the joystick 410 with the forefinger 490 of the right hand to perform remote control. In this instance, the IR transmission section 691A and the IR reception section 692A are opposed to the receiver 2 placed in front of the user.

Further, for example, when a telephone number list is displayed on the display apparatus 401, the telephone number list displayed on the display apparatus 401 can be scrolled by manually operating the joystick 410.

When a key displayed on the display section 430 is to be manually operated, since normally the cordless telephone set (child machine) 5 is held horizontally such that the portion of the cordless telephone set (child machine) 5 at which the loudspeaker 702 is located is directed toward the receiver 2 (the portion of the cordless telephone set (child machine) 5 at which the microphone 703 is located is directed toward the body of the user), the IR transmission section 691C and the IR reception section 692C are opposed to the receiver 2 placed in front of the user.

FIG. 20 shows an example of an internal construction of the child machine 5. An audio signal inputted from the microphone 703 is inputted to a transmission circuit 682, by which it is converted into a digital signal and modulated. The thus modulated audio signal is transmitted as a RF signal to the base unit 600 via an antenna 681.

A reception circuit 683 demodulates a RF signal received by the antenna 681, and outputs, from within the demodulated signal, an audio signal to the loudspeaker 702 but outputs a command to a microcomputer 684.

Also the microcomputer 684 includes a CPU, a ROM and a RAM not shown and controls various operations in response to an operation signal of the key set 701 displayed on the display section 430 or an operation signal from another keys such as the call button 402 or the memory button 403. Further, the microcomputer 684 controls the display section 430 so as to perform a predetermined displaying operation when necessary. Also an operation signal from the joystick 410 (body 161) is supplied to the microcomputer 684.

Further, the microcomputer 684 controls the IR transmission section 691 to generate an IR signal to be transmitted to the IR reception section 659 of the receiver 2 and fetches an IR signal from the IR transmission section 660 of the receiver 2 via an IR reception section 692.

Subsequently, operation of the receiver 2 when the numeral 0 key (which may be hereinafter referred to suitably as preview button) of the child machine 5 is manually operated will be described. When the preview button of the key set 701 displayed on the display section 430 is manually operated, a signal corresponding to the preview button is inputted from the tablet 431 to the CPU 29. In this instance, the microcomputer 684 controls the IR transmission section 691 to generate an IR signal corresponding to the input.

The IR reception section 659 of the receiver 2 receives the IR signal and outputs a result of detection to the CPU 29. In the ROM 37 of the receiver 2, information representing that the function applied to the numeral 0 key as a remote commander is a function of causing a multi-preview screen to be displayed is registered. Thus, in accordance with the registration, the CPU 29 instructs the front end circuit 20 to receive a transmission channel for archived data. In response to the instruction, archived data are supplied from the front end circuit 20 to the demultiplexer 24.

In particular, referring to FIG. 21, the tuner 21 receives and demodulates a signal from the transmission channel for exclusive use for a multi-screen. The output of the tuner 21 is then QPSK demodulated by the QPSK demodulation circuit 22, and then error correction processing of the output of the QPSK demodulation circuit 22 is performed by the error correction circuit 23. The output of the error correction circuit 23 is inputted to the demultiplexer 24. The data inputted to the demultiplexer 24 include packets of video data of six No.1 to No. 6 multi-screens described above and packets of audio data of the 54 programs.

If it is assumed that those packets have data IDs (packet IDs) of the numbers 1 to 6 added thereto, then the data having the data IDs of the numbers 1 to 6 are demultiplexed. Then, the data are decoded by corresponding ones of the MPEG video decoders 25-1 to 25-6 of the multi-channel real time decoder 25 and then supplied to and stored into the DRAMs 25a-1 to 25a-6. In particular, the multi-screen of the packet ID 1 is stored into the DRAMs 25a-1, and similarly, the multi-screens of the data IDs 2 to 6 are stored into the DRAMs 25a-2 to 25a-6, respectively.

Then, the six multi-screens stored in the DRAMs 25a-1 to 25a-6 are read out from them and developed and stored into the virtual frame memory 49 such that they may construct one virtual screen. In the arrangement shown in FIG. 21, the multi-screen indicated by No. 1 of the data ID 1 is arranged at the left upper corner of the virtual screen; the multi-screen indicated by No. 2 of the data ID 2 is arranged on the right side of the multi-screen of the data ID 1; the multi-screen indicated by No. 3 of the data ID 3 is arranged on the lower side of the multi-screen of the data ID 1; the multi-screen indicated by No. 4 of the data ID 4 is arranged on the right side of the multi-screen of the data ID 3; the multi-screen indicated by No. 5 of the data ID 5 is arranged on the lower side of the multi-screen of the data ID 3; and the multi-screen of the data ID 6 is arranged on the right side of the multi-screen of the data ID 5.

It is to be noted that, as described hereinabove, the data of the six multi-screens indicated by No. 1 to No. 6 are transmitted by one transmission channel (by a carrier from one transponder). Accordingly, even if the front end circuit 20 including the tuner 21 is provided by one as seen in FIG. 21, if the six MPEG video decoders 25-1 to 25-6 are provided, then six multi-screens can be received at a time and stored into the virtual frame memory 49.

If one or more multi-screens forming a multi-screen are transmitted via a transmission channel or channels corresponding to another transponder or transponders, then in order to receive the multi-screen of the transmission channel or one of the transmission channels, the reception frequency of the tuner 21 must be changed over, and after all, it is impossible to receive all multi-screens at a time (naturally this becomes possible if a plurality of front end circuits 20 are provided, which, however, complicates the construction and raises the cost). Therefore, only one transmission channel (common transmission channel) is preferably used to transmit the multi-screen.

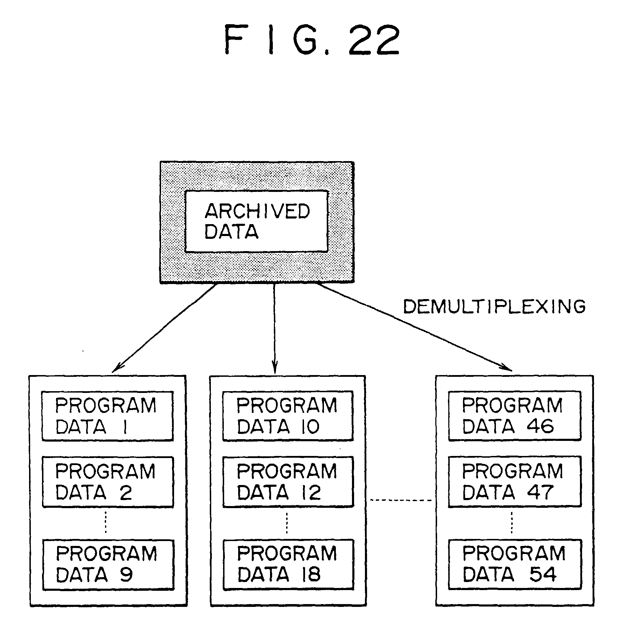

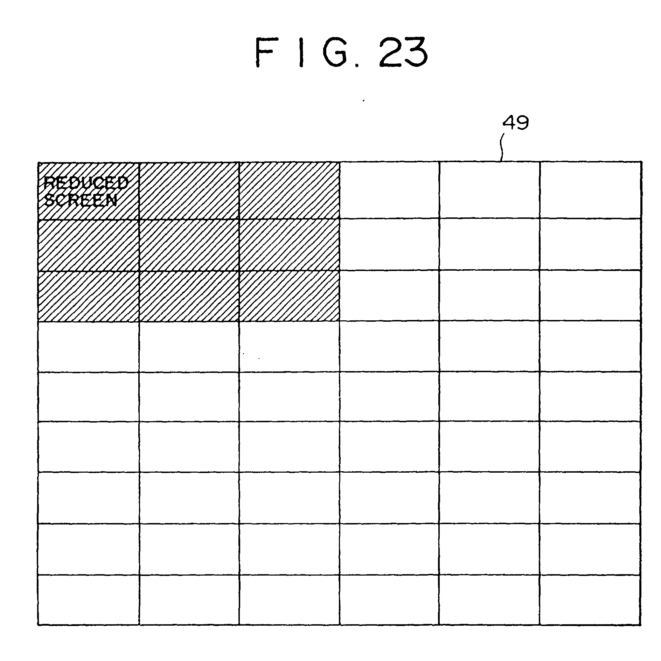

The processing of receiving a plurality of multi-screens from a single transmission channel (archived data) and storing the multi-screens into the virtual frame memory 49 is schematically illustrated in FIGS. 22 and 23.

In particular, when the demultiplexer 24 receives archived data which include six multi-screens, it separates the archived data into individual multi-screens as seen in FIG. 22. Then, the resulted six multi-screens are stored in a matrix into a virtual screen of the virtual frame memory 49 as seen in FIG. 23. Accordingly, the virtual frame can be considered to be a screen on which 6x9 reduced screens of programs of different broadcasting channels transmitted thereto from the broadcasting station are arranged. Since each of the reduced screens is an ordinary screen of a program of a reduced size, it exhibits an image of full motion of the frame rate of 30 fps (full moving picture), and accordingly, if the entire virtual frame is displayed, then contents of programs (reduced screens) of 54 broadcasting channels transmitted thereto from the broadcasting station can be observed in full motion.

Here, when the reduced screens are stored into the virtual frame memory 49, if the six multi-screens are not arranged as they are at the respective 2x3 predetermined positions of the virtual frame memory 49 but the individual reduced screens are managed independently of each other by the CPU 29 (picture element data of the virtual frame memory 49 are managed in units of 240 x 160 picture elements), then the reduced screens can be arranged at arbitrary positions of the 6x9 regions of the virtual frame memory 49.

In this instance, for example, the reduced screens may be arranged in order such that a predetermined number of them are arranged in the uppermost horizontal row of the virtual frame memory 49 from the left end toward the right and then next those of the same number are arranged in the second horizontal row from the left end toward the right, whereafter the other reduced screens are successively arranged in a similar manner, or may be arranged for individual program categories described hereinabove with reference to FIG. 5. When the reduced screens are arranged for individual program categories, the broadcasting station side (video server 53 side) may add to each reduced screen the category of a program corresponding to the reduced screen as EPG data. In this instance, the receiver 2 is constructed such that it reads the category of the program added to the reduced screen from the EPG data and arranges such reduced screens for individual program categories on the virtual frame memory 49.

Alternatively, it is possible to arrange reduced screens on the virtual frame memory 49 in a manner of arrangement desired by a viewer. In particular, where the broadcasting station side adds the category of a program to a reduced screen as described above, the receiver side apparatus can be constructed such that the cordless telephone set (child machine) 5 is manually operated to input a predetermined instruction to set the order of categories of programs so that reduced screens are successively arranged in the set order on the virtual frame memory 49 beginning with the uppermost horizontal low.

Further, for example, where the broadcasting station side adds to each reduced screen the broadcasting channel of a program corresponding to the reduced screen, the receiver side apparatus can be constructed such that the cordless telephone set (child machine) 5 is manually operated to set the order of broadcasting channels of programs so that reduced screens are successively arranged in the set order on the virtual frame memory 49 beginning with the uppermost horizontal row.

Further, since reduced screens stored in the virtual frame memory 49 are displayed on the monitor apparatus 4, it is possible to change the array positions of the reduced screens stored in the virtual frame memory 49 by inputting a predetermined instruction from the cordless telephone set (child machine) 5 while observing the display of the reduced screens.

Accordingly, in this instance, the reduced screens can be arranged in accordance with the preference of the viewer. In other words, the array of the reduced screens can be customized.

Further, where the broadcasting station side transmits reduced screens in a condition arranged for individual categories of programs as described hereinabove with reference to FIG. 5, the reduced screens can be stored in the arranged condition into the virtual frame memory 49. However, even if the reduced screens are transmitted in such an arranged condition for individual program categories, the reduced screens may be re-arranged in accordance with a manner of arrangement desired by the viewer as described above.

It is to be noted that such a manner of arrangement (array order) as mentioned above can be set by manually operating the cordless telephone set (child machine) 5 based on a predetermined menu screen displayed on the monitor apparatus 4 in response to a manual operation of a predetermined key of the cordless telephone set (child machine) 5. The manner of arrangement thus set is, for example, stored into the EEPROM 38. When a manner of arrangement is set in the EEPROM 38, the CPU 29 designates to the demultiplexer 24 an array order which is used to store reduced screens into the virtual frame memory 49. Then, the demultiplexer 24 stores the reduced screens into the virtual frame memory 49 in accordance with the array order designated from the CPU 29.

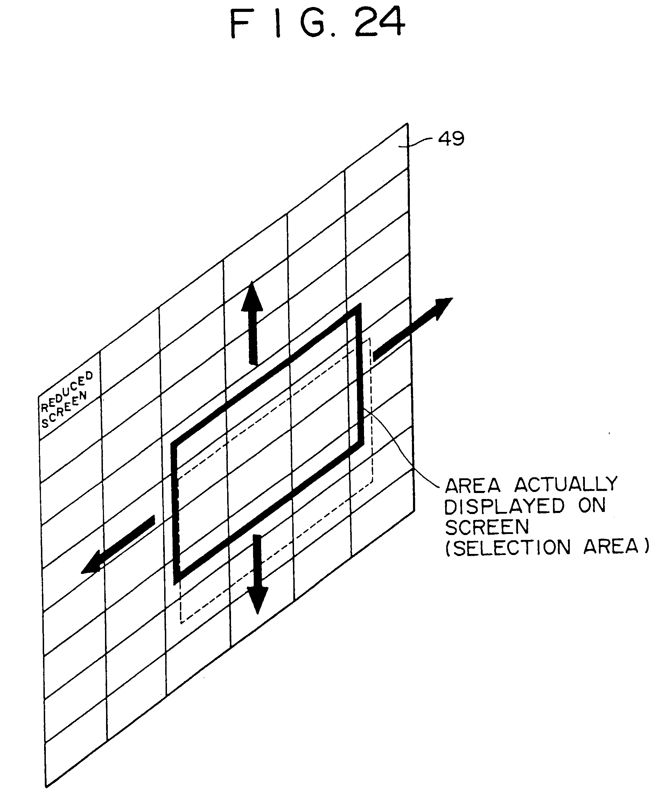

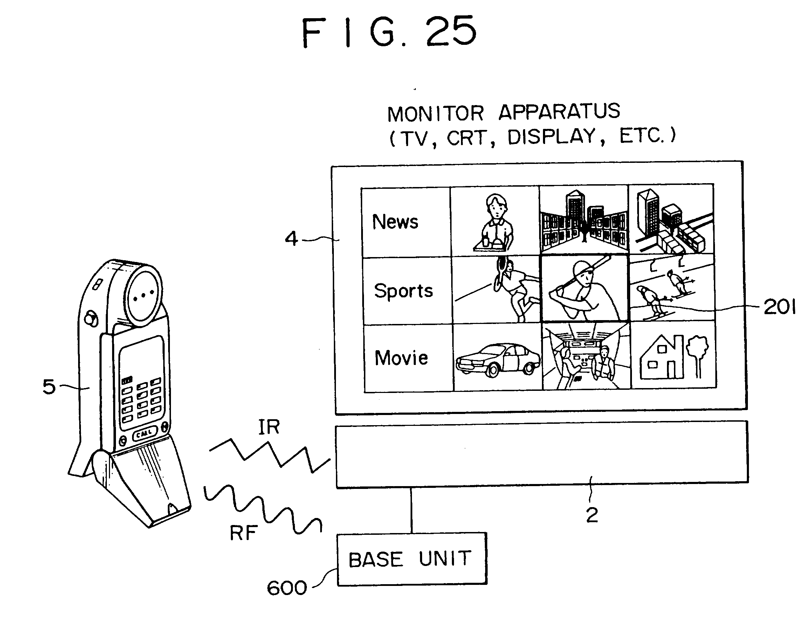

After the reduced screens are stored into the virtual frame memory 49, those of the reduced screens which are included in a range (selection area) within which they can be displayed at a time on one screen of the monitor apparatus 4 are designated by the CPU 29. In particular, in the present embodiment, since one reduced screen corresponds to a screen of an ordinary program which is reduced to 1/3 in vertical and horizontal lengths thereof as described above, for example, such 3x3 reduced screens surrounded by a thick line in FIG. 24 are read out. Then, the 3x3 reduced screens are supplied from the receiver 2 to the monitor apparatus 4 and displayed as a multi-preview screen on the monitor apparatus 4 as seen in FIG. 25.

Here, when a predetermined range (selection area) of 3x3 reduced screens from among the reduced screens stored in the virtual frame memory 49 is displayed as described above, it can be considered that the screen of the monitor apparatus 4 is used as such a metaphor that the reduced screens on the virtual frame memory 49 are partially peeped.

Then, in this instance, the monitor apparatus 4 displays, together with 3x3 reduced screens as a multi-preview screen, the cursor 201 in the form of a frame which surrounds a certain reduced screen as seen in, for example, in FIG. 25 in a superimposed condition by OSD display on the screen. It is to be noted that the cursor 201 is not limited to such a cursor in the form of a frame as described above, but may be any graphic form such as an arrow mark or the like only if it can be identified clearly for selection.

When the cursor 201 is positioned, for example, at a central one of 3x3 reduced screens, if the numeral 5 key (upward movement key) of the cordless telephone set (child machine) 5, the numeral 8 key (downward movement key), the numeral 4 key (leftward movement key) or the numeral 6 key (rightward movement key) is manually operated, then the cursor 201 is moved, in response to the direction of the operation, to a position surrounding a reduced screen displayed at the position upwardly, downwardly, leftwardly or rightwardly of the central reduced screen.

However, when the cordless telephone set (child machine) 5 is in a communication condition, since the display section 430 is positioned near to the face, the keys displayed on the display section 430 cannot be manually operated. However, in this instance, the joystick 410 can be manually operated to move the cursor.

Here, if any of the keys mentioned above is further manually operated directionally while the cursor 201 remains positioned at the upper, lower, left or right end of the screen of the monitor apparatus 4, the contents of the display of the monitor apparatus 4, that is, the multi-preview screen, is scrolled. For example, if a downward directional operation is performed while the cursor 201 is positioned at the lowest row of the multi-preview screen, then the multi-preview screen is scrolled upwardly by one row distance.

This scrolling is performed such that, for example, in place of the 3x3 reduced screens surrounded by a thick line in FIG. 24, other 3x3 reduced screens surrounded by a dotted line in FIG. 24 are read out from the virtual frame memory 49 and supplied to the monitor apparatus 4. It is to be noted that, since the cursor 201 remains stopping at the lowermost row, the cursor 201 is relatively moved downwardly by one row distance in the virtual frame memory 49 shown in FIG. 23 (or 24).

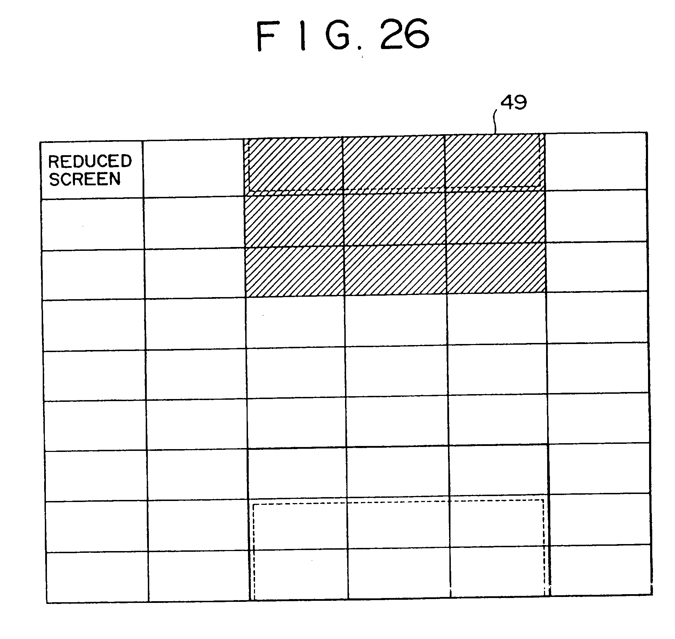

Further, when, for example, 3x3 reduced screens including reduced screens arranged in the lowermost row of the virtual frame memory 49 (3x3 reduced screens surrounded by a thick line in FIG. 26) are displayed on the monitor apparatus 4 while the cursor 201 remains at the lower end position of the screen of the monitor apparatus 4 as seen in FIG. 26, if a downward directional operation is performed, then the screen of the monitor apparatus 4 is scrolled. Consequently, 3x2 reduced screens in the lowermost row and the second lowermost row and 3x1 reduced screens in the uppermost row surrounded by dotted lines in FIG. 26 are displayed on the monitor apparatus 4.

Accordingly, when the 3x3 reduced screens surrounded by the thick line in FIG. 26 are displayed on the monitor apparatus 4 while the cursor 201 is at the lower end position of the screen of the monitor apparatus 4, if a downward directional operation is performed three times successively using the numeral 8 key, then 3x3 reduced screens including the reduced screens in the uppermost row and indicated by slanting lines in FIG. 26 are displayed.

Scrolling is performed in a similar manner with regard to the upward, leftward or rightward direction.

Such scrolling is performed as a signal (operation signal) corresponding to a directional operation of the numeral 2, 8, 4 or 6 key or a directional operation of the joystick 410 is received by the CPU 29 of the receiver 2 and the read address of the virtual frame memory 49 is controlled in response to the received operation signal by the CPU 29. In particular, the CPU 29 recognizes, based on the received operation signal, a range of reduced screens to be displayed on the monitor apparatus 4. Then, the CPU 29 delivers an instruction to the virtual frame memory 49 to read out the reduced screens in the thus recognized range. Consequently, the reduced screens (some reduced screens) within the instructed range are read out from the virtual frame memory 49 and outputted to the monitor apparatus 4. As a result, the screen of the monitor apparatus 4 is scrolled.

Accordingly, in this instance, the directional operation can be considered to be an operation for designating reduced screens to be read out from the virtual frame memory 49.

Since the multi-preview screen is scrolled as described above, even if the number of programs is greater than the number of programs of reduced screens which can be displayed at a time on the monitor apparatus 4, the multi-preview screen of all programs can be provided to the viewer.

While observing such reduced screens of full motion displayed on the monitor apparatus 4 as shown in FIG. 25, the viewer performs a directional operation to move the cursor 201 to a desired reduced screen. Then, if the numeral 5 key (YES key) is manually operated or the joystick 410 is manually operated (selection operation) in order to settle selection of the television program while the cursor 201 is positioned at the desired reduced screen, the CPU 29 sends an instruction to the front end circuit 20 to receive the program of a broadcasting channel linked to the selected reduced screen.

In response to the instruction, the tuner 21 of the front end circuit 20 is tuned to the transmission channel of the instructed program and outputs packet data of a plurality of programs included in the transmission channel to the demultiplexer 24. The demultiplexer 24 separates the packet of a predetermined program from within the packets of the plurality of programs in response to the instruction from the CPU 29 and outputs the separated packet to the MPEG video decoder 25-1. Decoded data from the MPEG video decoder 25-1 are processed by the NTSC encoder 27 and outputted to the monitor apparatus 4 via the succeeding blocks. The monitor apparatus 4 thus displays, in place of the multi-preview screen, an image of the program outputted from the receiver 2.

In short, the viewer can directly and intuitively select and enjoy a desired program by moving the cursor 201 to a desired reduced screen and then performing a selection operation.

It is to be noted that sound is incidental to the multi-screen, and the demultiplexer 24 separates a packet of an audio signal corresponding to a reduced screen at which the cursor 201 is positioned (sound of a program corresponding to the reduced screen) and supplies the audio signal to the MPEG audio decoder 26 so that the audio signal may be decoded by the MPEG audio decoder 26. Consequently, the viewer can observe the reduced screen of full motion at which the cursor 201 is positioned and can listen to sound incidental to the reduced screen simultaneously on the real time basis.

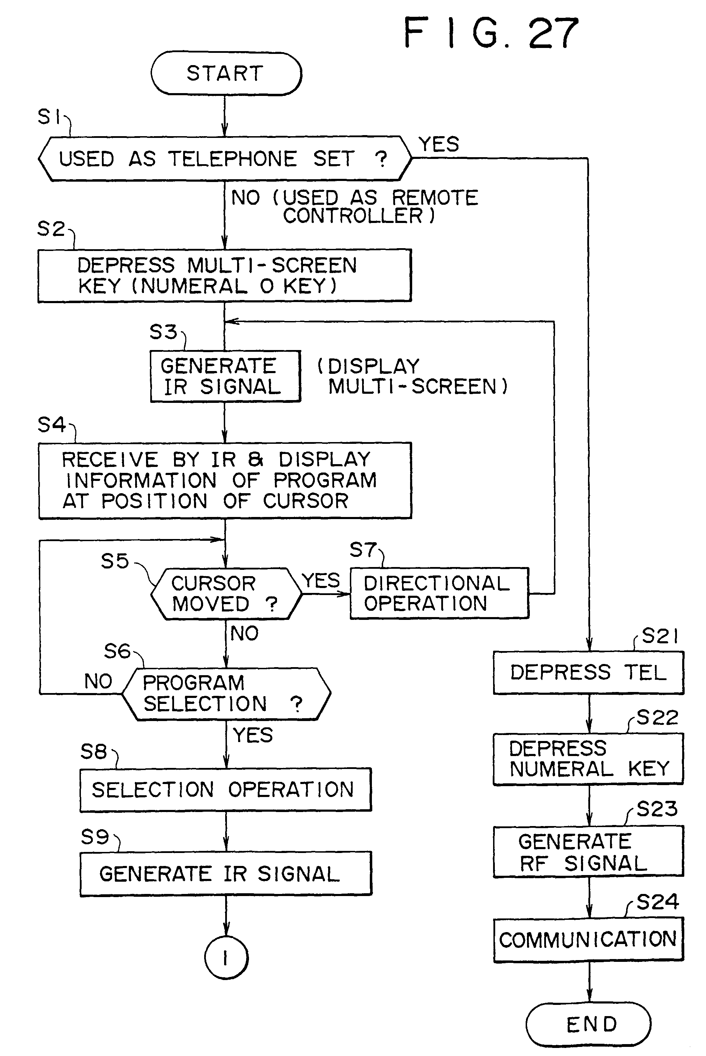

While operation for selecting a desired program from within a program selection screen is described above, a general manner of use of the child machine 5 is illustrated in FIGS. 27 and 48.

Referring first to FIG. 27, it is determined first at step S1 by a user whether the child machine 5 should be used as a telephone set or as a remote commander for remotely controlling the receiver 2 (monitor apparatus 4) as an electronic apparatus. Where the receiver 2 (monitor apparatus 4) should be used as a remote commander, the control sequence advances to step S2, at which the preview button (numeral 0 key) is manually operated. Then at step S3, an IR signal corresponding to the preview button is generated. As described hereinabove, in response to the IR signal from the child machine 5, the CPU 29 interprets a function allocated to a code of the numeral 0 and controls, in accordance with the interpretation, the tuner 21 to receive a program selection screen so as to be displayed. Further, the CPU 29 controls the tuner 21 to display the cursor 201 at a predetermined default position.

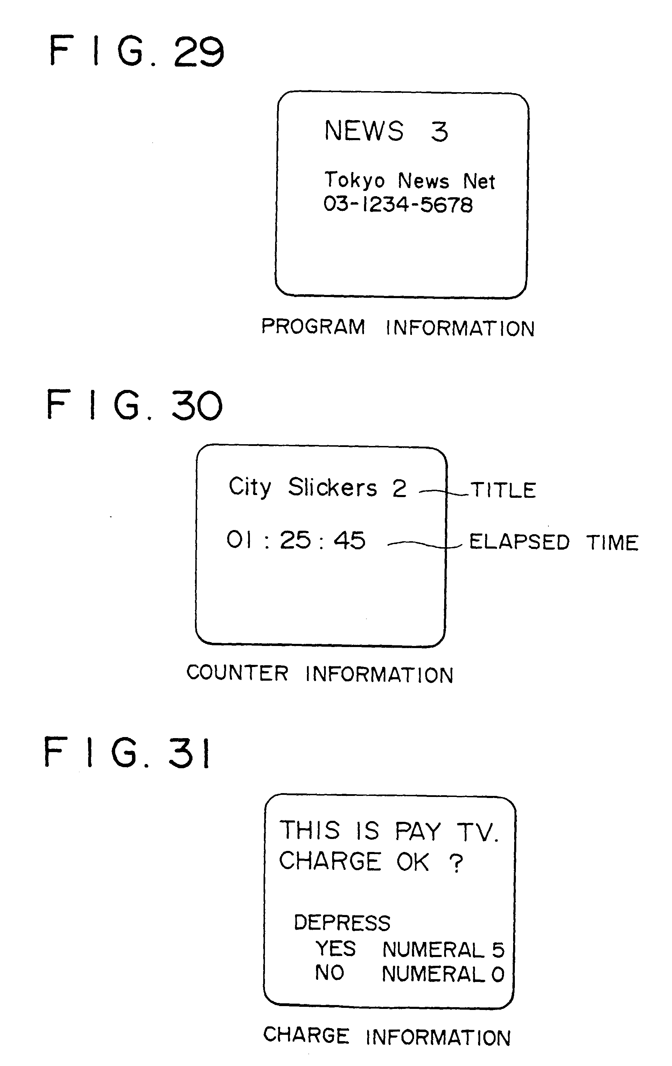

Then, the CPU 29 reads out EPG data of a reduced screen at which the cursor is positioned from the data buffer memory 35 and outputs the EPG data from the IR transmission section 660. The child machine 5 receives, at step S4, the EPG data at the IR reception section 692 and displays the EPG data on the display section 430. Consequently, program information wherein contents of the program of the reduced screen at which the cursor 201 is positioned are described in characters (in FIG. 29, a title of the program, a broadcasting channel and a telephone number) is displayed as shown in FIG. 29. Or, as shown in FIG. 30, counter information representative of an elapsed time of the program of the reduced screen (in FIG. 30, a title of the program and an elapsed time after a start of broadcasting) may be displayed. The user can select a program referring to the displayed information.

It is theoretically possible to display characters incidental to a program of a reduced screen within the reduced screen. However, such display will make it difficult to discern characters. Therefore, it is preferable to display such incidental characters on the display section 430 of the cordless telephone set (child machine) 5 as a remote commander which can be located at hand of the user as in the present embodiment.

Then, the control sequence advances to step S5, at which the user determines whether the cursor 201 should be moved to some other reduced screen. When the cursor 201 is moved, the control sequence advances to step S7, at which the user manually operates one of the directional movement keys including the numeral 2, 8, 4 and 6 keys or directionally operates the joystick 410. Then, the control sequence returns to step S3, at which the microcomputer 684 controls the IR transmission section 691 to transmit a code corresponding to the operated key as an IR signal. When the code is received by the IR reception section 659, the CPU 29 interprets a function corresponding to the code and moves the cursor 201 in a direction corresponding to the operated key in accordance with the interpretation (movement of the cursor).

On the other hand, when the user determines at step S5 that the cursor should not be moved, the control sequence advances to step S6, at which it is determined whether or not the program should be selected. If the program should not be selected as yet, the control sequence returns to step S5.

On the contrary, when it is determined at step S6 that the program should be selected, the control sequence advances to step S8, at which either the YES key (numeral 5 key) is manually operated or the joystick 410 is manually operated for selection. Then at step S9, an IR signal corresponding to the numeral 5 or the selection operation of the joystick 410 is transmitted so that a code corresponding to the numeral 5 or the selection operation of the joystick 410 is supplied to the CPU 29. The CPU 29 interprets a function corresponding to the numeral 5 or the selection operation of the joystick 410 as settlement of the program. The CPU 29 controls the tuner 21 to receive the designated program in accordance with the interpretation.

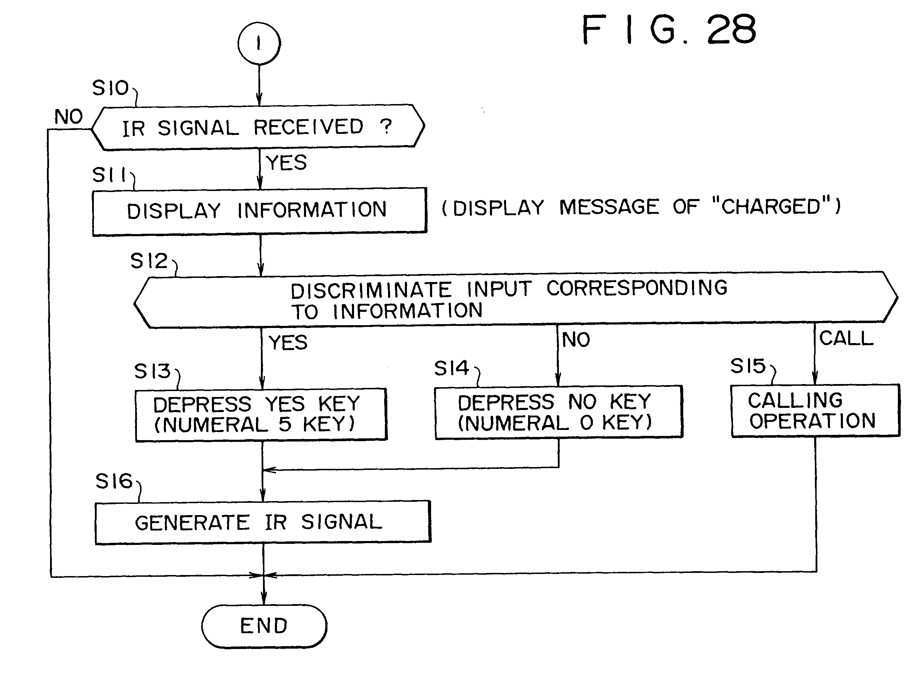

Then, the control sequence advances to step S10 illustrated in FIG. 28. Referring to FIG. 28, at step S10, the microcomputer 684 discriminates whether or not an IR signal is received from receiver 2, and if no IR signal is received, then the microcomputer 684 stops its processing. In this instance, the program designated on the program selection screen is displayed in a full size on the monitor apparatus 4.

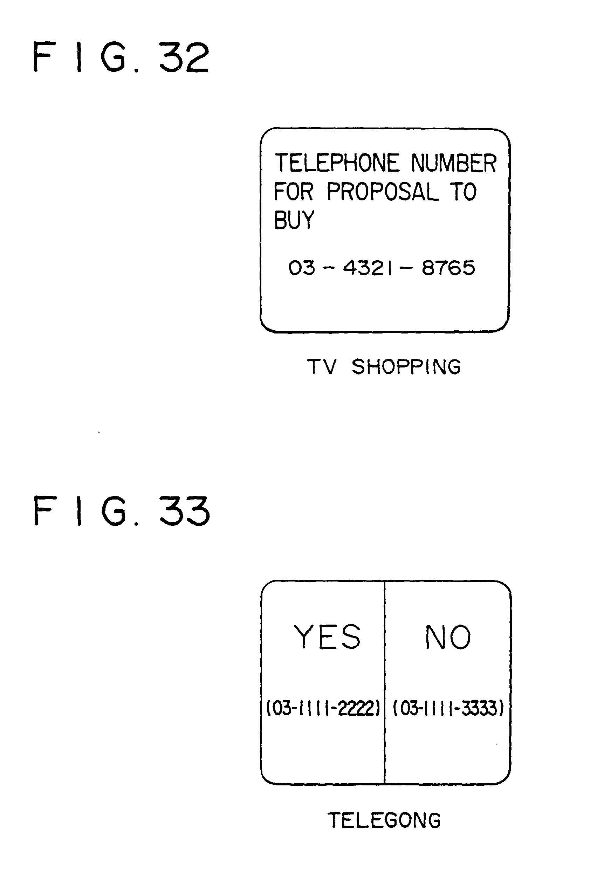

On the other hand, when it is discriminated at step S10 that an IR signal is received, the control sequence advances to step S11, at which the received information is displayed on the display section 430. For example, if the selected program is a chargeable program (pay purview program), a message inquiring whether or not a charge is acceptable is displayed as seen in FIG. 31. At step S12, the user determines an input corresponding to the message.

When a charge is accepted, the control sequence advances to step S13, at which the YES key (numeral 5 key) is manually operated. Then at step S16, an IR signal corresponding to the key is generated. In response to the IR signal, the CPU 29 controls the monitor apparatus 4 to display the program in a full size. If a charge is not acceptable and another program should be selected, the user manually operates the NO key (numeral 0 key) at step S14. Then at step S16, an IR signal corresponding to the key is generated. In response to the IR signal, the CPU 29 inhibits reception of the program.

Or, for example, in a program for television shopping, a broadcasting station may transmit a telephone number for accepting an order of a commodity as EPG data. The receiver 2 reads out and transmits the EPG data to the child machine 5. The microcomputer 684 of the child machine 5 controls the display section 430 to display the EPG data, for example, as shown in FIG. 32 and stores the telephone number in the EPG data into the built-in RAM thereof. When the user intends to purchase the commodity, the user manually operates, at step S15, the call button 402 of the child machine 5 to develop an instruction for a call originating operation.

When the call button 402 is manually operated, the microcomputer 684 starts a call originating operation to the telephone number stored in the built-in RAM (details of a call originating operation will be hereinafter described). In particular, in this instance, the user need not input numerals of the telephone number displayed on the display section 430 but can start a call originating operation to the displayed telephone number only by manual operation of one button (call button 402).

Else, for example, in a telegong program, it is assumed that those who are for a particular question dial a first telephone number whereas those who are against the question dial a second telephone number. In this instance, a broadcasting station transmits the characters YES and the first telephone number as well as the characters NO and the second telephone number as EPG data. When the EPG data are received via the receiver 2, the microcomputer 684 of the child machine 5 controls the display section 430 to display the characters YES and the characters NO as seen in FIG. 33 (naturally the first telephone number and the second telephone number may be displayed together).

When the user is for the question, the user depresses a region of the display section 430 in which the characters YES are displayed, but when the user is against the question, the user depresses the other region of the display section 430 in which the characters NO are displayed. Which one of the regions is depressed is detected by the tablet 431. The microcomputer 684 automatically performs a call originating operation to one of the first telephone number and the second telephone number which corresponds to a result of the detection.

In contrast, referring back to FIG. 27, when it is discriminated at step S1 that the child machine 5 is used as a telephone set, the control sequence advances to step S21, at which the TEL key is depressed first (the TEL key may otherwise be provided as a real button similarly to the call button 402 or the memory button 403). In this instance, the microcomputer 684 sets a telephone mode, in which it thereafter processes numerals and symbols inputted from the tablet 431 as an input for a telephoning operation.

Thus, the control sequence advances to step S22, at which the user depresses the numeral keys to input a telephone number (where a telephone number is stored in the RAM as described hereinabove, this is read out from the RAM). The microcomputer 684 of the child machine 5 controls, at step S23, the transmission circuit 682 to transmit to the base unit 600 an RF signal obtained by modulating a predetermined carrier with a signal corresponding to each manually operated key.

In the base unit 600, the reception circuit 654 receives the signal via the antenna 655. When an input of a detection signal of the received signal is received via the reception circuit 654, the microcomputer 656 controls the DTMF encoder 652 via the line interface 651 to generate a DTMF signal corresponding to the manually operated numeral key. The DTMF signal is transmitted to the receiver 2 via the line interface 651 and the modular jack 601.

In the modem unit 631 of the receiver 2, the DTMF signal is inputted to the modem 632 via the modular jack 636 and the external telephone off-hook detection circuit 634. When the DTMF signal is inputted in a telephone mode of the telephone set, the modem 632 transmits the DTMF signal to a telephone line via the modular jack 635. Consequently, a call originating operation is performed.

The modem 632 closes the telephone line when it detects from reversal of the polarity of the telephone line or the like that the other party has responded to the call originating operation.

As a result, received speech transmitted thereto from the other party via the telephone line is inputted to the base unit 600 via the external telephone off-hook detection circuit 634. The line interface 651 of the base unit 600 supplies the receives speech to the transmission circuit 653 so that it is transmitted to the child machine 5 via the antenna 655.

In the child machine 5, the received speech is received by the reception circuit 683 via the antenna 681 and outputted from the loudspeaker 702.

On the other hand, transmission speech inputted from the microphone 703 is transmitted from the transmission circuit 682 to the base unit 600 via the antenna 681.

In the base unit 600, the transmission speech is received by the reception circuit 654 via the antenna 655 and is outputted to the modem unit 631 of the receiver 2 via the line interface 651. The transmission speech is transmitted to the telephone line via the external telephone off-hook detection circuit 634. Communication processing at step S24 is performed in this manner.

When a call signal is inputted from the other party via a telephone line, the call signal is inputted to the base unit 600 via the modem unit 631. When the call signal is inputted via the line interface 651, the reception circuit 654 detects this and outputs a detection signal to the microcomputer 656.

In this instance, the microcomputer 656 controls the transmission circuit 653 to generate a ringer sound signal so as to be outputted from a loudspeaker not shown. The ringer sound signal is also transmitted from the transmission circuit 653 to the child machine 5 via the antenna 655. In the child machine 5, the ringer sound signal is received by the reception circuit 683 and outputted from the loudspeaker 702. Consequently, the user can get aware of the terminating call.

It is to be noted that a predetermined setting may be performed to prevent ringer sound from being outputted from the child machine 5.

When to respond to the terminating call, the user manually operates the TEL key. In this instance, the microcomputer 684 controls the transmission circuit 682 to generate a response signal.

When an input of a detection signal of the response signal is received from the reception circuit 654, the microcomputer 656 of the base unit 600 controls the reception circuit 654 to generate an off-hook signal. The off-hook signal is transmitted via the line interface 651 to and detected by the external telephone off-hook detection circuit 634 of the modem unit 631. When the off-hook signal is detected, the modem 632 closes the telephone line. Consequently, subsequent communication is permitted.

In this manner, in the present embodiment, since communication is performed using a RF signal and remote control is performed using an IR signal, the receiver 2 can be remotely controlled with certainty even during communication of the telephone set.

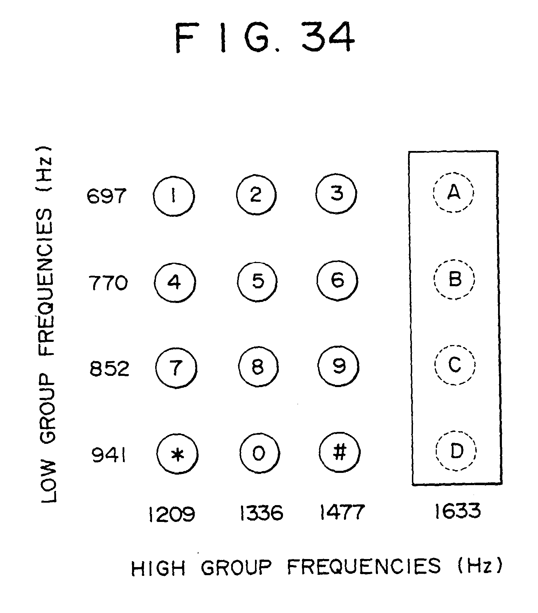

FIG. 34 illustrates a construction of a DTMF (Dual Tone Multi Frequency) signal. As seen in FIG. 34, in the DTMF signal, a mixed signal of two frequencies of a low group frequency and a high group frequency is allocated to each key. As seen in FIG. 34, the low group frequency is one of 697 Hz, 770 Hz, 852 Hz and 941 Hz while the high group frequency is one of 1,209 Hz, 1,336 Hz, 1,477 Hz and 1,633 Hz. Those frequencies are allocated to the individual keys.

For example, to the numeral 1 key, the low group frequency of 697 Hz and the high group frequency of 1,209 Hz are allocated. To the numeral 2 key, the low group frequency of 697 Hz and the high group frequency of 1,336 Hz are allocated.

It is to be noted that, to the TEL key shown in FIG. 10, the low group frequency of 697 Hz and the high group frequency of 1,633 Hz at a position indicated by character A in FIG. 34 are allocated.

Accordingly, for example, if the numeral 1 key is manually operated, the DTMF encoder 652 outputs a mixed signal of signals of the two different frequencies of 697 Hz and 1,209 Hz as a DTMF signal. On the other hand, when the numeral 2 key is manually operated, a mixed signal of a signal of the frequency of 697 Hz and another signal of the frequency of 1,336 Hz is generated as a DTMF signal.

When the DTMF signal is received, the DTMF decoder 633 generates a code corresponding to the numeral or symbol. For example, when a DTMF signal of the frequencies of 697 Hz and 1,336 Hz is detected, the DTMF decoder 633 outputs a code of the numeral 2.

While, in the foregoing description, a DTMF signal generated by the base unit 600 is utilized, where the child machine 5 includes a built-in DTMF encoder, a DTMF signal generated by the child machine 5 may be utilized instead.

It is to be noted that, while, in the present embodiment, 3x3 reduced screens are displayed at a time on the monitor apparatus 4 in order to allow selection of a program, the number of reduced screens to be displayed at a time on the monitor apparatus 4 is not limited to the specific number. In particular, for example, 4x4 reduced screens or 3x2 reduced screens can be displayed at a time on the monitor apparatus 4 based on, for example, the resolution of the monitor apparatus 4 or some other parameter (however, the size of one reduced screen must be even at the smallest such that, when observing the reduced screen, the viewer can understand contents of the program).

Further, while, in the present embodiment, reduced screens are arranged in a matrix on the virtual frame memory 49, it is otherwise possible, for example, to store reduced screens into a predetermined storage area and store addresses, at which the reduced screens are stored, in a matrix in the virtual frame memory 49. In this instance, an address stored in the virtual frame memory 49 may be referred to read out a reduced screen stored at the address and display the reduced screen. Further, also the processing of customizing and arranging reduced screens for individual categories may be modified such that, without changing the arrangement on the virtual frame memory 49, reduced screens only of a predetermined category are read out and displayed as a multi-preview screen.

Further, while the receiver 2 and the monitor apparatus 4 in the present embodiment are constructed as independent apparatus of each other, the receiver 2 and the monitor apparatus 4 may otherwise be formed as a unitary member.

Further, while, in the present embodiment, reduced screens are arranged, upon arrangement for individual categories, such that reduced screens of the same category are arranged in a horizontal row (horizontal direction), reduced screens of the same category may otherwise be arranged in a vertical column (vertical direction).

Further, while, in the present embodiment, data for program selection to be transmitted are reduced screens of moving pictures obtained by reduction of screens of ordinary programs, still pictures or text data representative of contents of programs may alternatively be used as the data for program selection.

Further, while, in the present embodiment, data for program selection are transmitted, such data for program selection may alternatively be produced, for example, on the viewer side. In particular, it is possible to produce, on the viewer side, reduced screens or some other data representative of contents of programs from ordinary programs received and use them as data for program selection.

Further, while, in the present embodiment, the screen is scrolled so that all data for program selection may be observed, it is otherwise possible to change over the screen, for example, in a page turning manner so that all data for program selection may be observed.

The invention may be embodied in other specific forms without departing from the essential characteristics thereof. The present embodiments are therefore to be considered in all respects as illustrative and not restrictive, the scope of the invention being indicated by the appended claims rather than by the foregoing description and all changes which come within the meaning and range of equivalence of the claims are therefore intended to be embraced therein.

## Claims

1. An electronic apparatus (2) to which a program-related information display apparatus is applied, said electronic apparatus being remotely controllable by a remote commander (5) and comprising
program reception means (21) for receiving a program and character information relating to the program transmitted thereto over a channel, and
characterised by further comprising
character information transmission means (660) for transmitting the character information to said remote commander (5) in order to cause said remote commander (5) to display the character information.

2. An electronic apparatus to which a program-related information display apparatus is applied according to claim 1, wherein the character information is character information relating to a program of a program selection screen which includes a plurality of reduced screens reduced from different programs.

3. An electronic apparatus to which a program-related information display apparatus is applied according to claim 1 or 2, further comprising control signal reception means (659) for receiving a control signal relating to the transmitted character information from said remote commander (5).

4. An electronic apparatus to which a program-related information display apparatus is applied according to claim 3, wherein the character information is any one or more of program information representative of contents of the program, counter information representative of an elapsed time of the program, charge information regarding a charge for reception of the program, a telephone number relating to the program and questionnaire information relating to the program.

5. An electronic apparatus to which a program-related information display apparatus is applied according to any one of the preceding claims, wherein said remote commander (5) serves also as a cordless telephone set, and further comprising communication means (653, 654) for communicating transmission speech and reception speech with said cordless telephone set.

6. An electronic apparatus to which a program-related information display apparatus is applied according to claim 5 when appendant to claim 3, wherein said character information transmission means (660) and said control signal reception means (659) transmit the character information and a control signal by infrared rays, respectively, and said communication means (653, 654) transmits and receives the transmission speech and the reception speech by radio waves.

7. An electronic apparatus to which a program-related information display apparatus is applied according to claim 1, further comprising display means (4) for displaying the program.

8. A program-related information displaying method, comprising the steps of:
receiving a program and character information relating to the program transmitted over a channel by an electronic apparatus (2) which is remotely controllable by a remote commander (5); and
transmitting the character information from said electronic apparatus to said remote commander (5) so as to be displayed on said remote commander (5).

9. A remote commander to which a program-related information display apparatus is applied, said remote commander (5) being adapted to remotely control an electronic apparatus (2) which receives a program transmitted thereto over a channel, said remote commander comprising:
character information reception means (692) for receiving character information relating to the program transmitted thereto from said electronic apparatus; and
display means (430) for displaying the character information received by said character information reception means.

10. A remote commander to which a program-related information display apparatus is applied according to claim 9, further comprising generation means (684) for generating, while the character information received by said character information reception means is displayed on said display means (430), a control signal relating to the character information.

11. A remote commander to which a program-related information display apparatus is applied according to claim 10, further comprising communication means (682, 683) for communicating transmission speech and reception speech with said electronic apparatus.

12. A remote commander to which a program-related information display apparatus is applied according to claim 11, further comprising call origination means (684) for performing, when a key is operated while a telephone number is displayed as the character information received by said character information reception means (692) on said display means, a call origination operation to the telephone number.

13. A program relating information displaying method, comprising the steps of:
receiving character information transmitted from an electronic apparatus (2), which receives a program transmitted thereto over a channel, and relating to the program, by means of a remote commander (5) which is adapted to remotely control said electronic apparatus (2); and
displaying the received character information on said remote commander (5).

14. A remote control method for remotely controlling an electronic apparatus (2), which receives a program transmitted thereto over a channel, by means of a remote commander (5) which is capable of functioning as a telephone set, said remote control method being performed incidentally to a program-related information displaying method, said remote control method comprising the steps of:
receiving character information transmitted from said electronic apparatus (2) and relating to the program by means of said remote commander (5);
displaying the received character information on said remote commander (5); and
performing, when a key is operated while a telephone number is displayed as the received character information on said remote commander, a call originating operation to the telephone number.
